(19) Europäisches Patentamt

European Patent Office

Office européen des brevets

(11) **EP 2 833 554 B1**

(12) **EUROPEAN PATENT SPECIFICATION**

(45) Date of publication and mention
of the grant of the patent:
**28.03.2018 Bulletin 2018/13**

(51) Int Cl.:
*H03M 13/11* (2006.01)          *H03M 13/25* (2006.01)
*H04B 10/61* (2013.01)          *H04L 1/00* (2006.01)
*H03M 13/00* (2006.01)

(21) Application number: **13306105.1**

(22) Date of filing: **31.07.2013**

(54) **Encoder and decoder**

Kodierer und Dekodierer

Codeur et décodeur

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.02.2015 Bulletin 2015/06**

(73) Proprietor: **ALCATEL LUCENT**
**92100 Boulogne-Billancourt (FR)**

(72) Inventors:
• **Schmalen, Laurent**
**70435 Stuttgart (DE)**
• **Pepe, Marianna**
**20059 Vimercate, MI (IT)**

(74) Representative: **Menzietti, Domenico**
**Alcatel Lucent**
**Intellectual Property & Standards**
**70430 Stuttgart (DE)**

(56) References cited:
**EP-A1- 2 506 516          EP-A2- 2 051 386
WO-A1-2006/055086**

• **Anonym: "Report Concerning Space Data
System Standards GREEN BOOK TM
SYNCHRONIZATION AND CHANNEL CODING-
SUMMARY OF CONCEPT AND RATIONALE", , 1
November 2012 (2012-11-01), pages 1-127,
XP055091069, Washington, DC, USA Retrieved
from the Internet:
URL:http://public.ccsds.org/publications/a
rchive/130x1g2.pdf [retrieved on 2013-12-02]**
• **SEHO MYUNG ET AL: "Lifting Methods for
Quasi-Cyclic LDPC Codes", IEEE
COMMUNICATIONS LETTERS, IEEE SERVICE
CENTER, PISCATAWAY, NJ, US, vol. 10, no. 6, 1
June 2006 (2006-06-01), pages 489-491,
XP001546983, ISSN: 1089-7798, DOI:
10.1109/LCOMM.2006.1638625**
• **HOCEVAR D E: "A Reduced Complexity Decoder
Architecture via Layered Decoding of LDPC
Codes", IEEE WORKSHOP ON SIGNAL
PROCESSING SYSTEMS 2004 (SIPS 2004), 13-15
OCTOBER 2004, IEEE, 13 October 2004
(2004-10-13), pages 107-112, XP010743944, DOI:
10.1109/SIPS.2004.1363033 ISBN:
978-0-7803-8504-7**

**Description**

Embodiments of the present invention relate to communication systems and, more particularly, to communication systems employing Low-Density Parity-Check (LDPC) Codes.

Background

This section introduces aspects that may be helpful in facilitating a better understanding of the inventions. Accordingly, the statements of this section are to be read in this light and are not to be understood as admissions about what is in the prior art or what is not in the prior art.

Low-Density Parity-Check (LDPC) codes are for example described in the Report Concerning Space Data System Standards, GREEN BOOK, "TM SYNCHRONIZATION AND CHANNEL CODING- SUMMARY OF CONCEPT AND RATIONALE", 1 November 2012, pages 1-127, XP055091069, Washington, DC, USA. A Low-Density Parity-Check (LDPC) Code is a linear error correcting code for transmitting a message over a noisy transmission channel, and may be constructed using a sparse bipartite graph whose vertices can be divided into two disjoint independent sets $U$ and $V$ such that every edge connects a vertex in $U$ to one in $V$. An example of a bipartite graph used for LPDC codes is the so-called Tanner graph. In coding theory, Tanner graphs may also be used to construct longer codes from smaller ones. Both LPDC encoders and LPDC decoders may employ these graphs extensively.

An important application of LDPC codes is in optical or wireless communication systems. As the LDPC codes used in optical communications are mainly high-rate LDPC codes with rates higher than 0.8 (overhead smaller than 25%), these LDPC codes are usually based on parity check matrices of size $M$ (rows) $\times$ $N$ (columns), with $M << N$. It is well-recognized that LDPC codes perform remarkably well assuming that a carrier phase is perfectly synchronized and coherent detection is performed. It should be noted however that, due to practical issues like complexity, acquisition time, sensitivity to tracking errors, and phase ambiguity, coherent detection may become expensive or infeasible in some cases. For example, in optical communications a signal received after carrier recovery may be affected by phase slips, with a probability depending on a (possibly non-linear) phase noise introduced by an optical transmission link, such as a fiber, for example. If the phase slip is not recovered correctly, error propagation may occur at the receiver and data following the phase slip may not be properly corrected by a decoder.

When transmitting a signal over a transmission channel, the signal's phase may be degraded by a phase offset that may be estimated at the receiver. The phase of a Phase-Shift Keying (PSK) modulated signal may then be corrected by this estimated phase offset. The estimated phase offset may be erroneous to a degree, such that the correction of the received signal causes a rotation of the PSK constellation diagram by a whole numbered multiple of the separation angle from the receiver's perspective. Such a rotation of the constellation diagram occurs from the time instant of one data symbol to a next time instant of a next successive data symbol and is called a phase slip. A typical value for a probability of a phase slip is for example $10^{-3}$.

In such scenarios a technique of differential encoding becomes relevant. Differential encoding admits simple non-coherent differential detection which solves phase ambiguity and requires only frequency synchronization (often more readily available than phase synchronization). Viewed from the coding perspective, performing differential encoding is essentially concatenating the original code with an accumulator, or, a recursive convolutional code.

When regarding iterative decoding of a Forward Error Correction (FEC) code, such as LDPC, and a differential code, the random phase slips on a transmission channel can be taken into account by an appropriately chosen clipping function (S-Function) which may be inserted in an iterative loop between the differential decoder and FEC decoder. The advantage of this solution is that a standard differential decoder with soft-output decoding can be utilized. Such a decoder may be commonly based on the trellis representation using the MAP/BCJR (MAP = Maximum A Posteriori; BCJR = Bahl, Cocke, Jelinek and Raviv) algorithm. The drawback of this solution is however that the Very-Large-Scale Integration (VLSI) implementation is complicated due to the presence of two different decoding domains. Thereby VLSI commonly denotes a process of creating integrated circuits by combining thousands of transistors into a single chip.

If the probability of occurrence of phase slips is rare, which can be ensured by optimized phase estimators and transmission lines, it is desirable to improve existing solutions to achieve the same coding gains with lower implementation complexity.

Summary

This is achieved by transmitters, receivers, methods, and computer programs according to the independent claims.

One idea of embodiments is to employ a modified LDPC code construction that allows parts of a received LDPC code word to be sign-inverted, for example, due to a phase slip. The proposed LDPC codes can stay agnostic to this sign flip and they remain after decoding and correcting the transmission errors. The decoded code word may then be decoded by a differential decoder to remove the ambiguities. The remaining errors, which are due to the fact that the phase slips do not occur at the specific boundaries of the parts to be sign-inverted, may be corrected by a strong outer code. Hence, embodiments propose to exchange the role of LDPC and differential encoder compared with existing schemes, where the differential encoder is frequently used as an inner component in a serially concatenated system.

Hence, according to a first aspect some embodiments provide an encoder. The encoder comprises a differential encoder which is operable or configured to provide a differentially encoded signal based on an input signal and a differential encoding rule. Thereby, differential coding makes data to be transmitted to depend not only on a current bit (or symbol), but also on the previous one(s). Further, the encoder comprises an LDPC encoder which is operable or configured to provide an LDPC encoded signal based on the differentially encoded signal and based on an LDPC encoding rule. Thereby the LDPC encoding rule is based on or corresponds to an $M'S \times N'S$ parity check matrix defining the LDPC code, with $M'S$ denoting the number of rows of the parity check matrix, $N'S$ denoting the number of columns of the parity check matrix, and $M'$, $N'$, $S$ denoting integer numbers. $M'$, $N'$ may denote the number of columns and rows of an associated lifting matrix. The parity check matrix comprises a plurality of (non-zero) $S \times S$ permutation sub-matrices, e.g., a circulant $S \times S$ matrix, with an even number of non-void or non-zero entries in each row of an $S \times S$ sub-matrix. This may hold for each $S \times S$ sub-matrix or only for a portion of the plurality of the $S \times S$ sub-matrices.

According to some embodiments the encoder may serve for performing a corresponding encoding method comprising an act of differentially encoding an input signal based on a differential encoding rule to obtain a differentially encoded signal, and an act of LDPC encoding the differentially encoded signal based on an LDPC encoding rule corresponding to an $M'S \times N'S$ parity check matrix comprising a plurality of (non-zero) $S \times S$ permutation (e.g., circulant) sub-matrices with an even number of non-void or non-zero entries in each row of an $S \times S$ sub-matrix. The encoder may for example be comprised by an optical communications device, such as an optical transmitter, which may comprise further transmitter circuitry, such as mixers, Digital-to-Analog Converters (DACs), modulators, outer encoders, analog and/or digital signal processors, etc. The LDPC encoded signal may further be transmitted over an optical communication channel, such an optical fiber, for example. However, it will be appreciated by the skilled person that embodiments may also be beneficial for other than optical communication systems, such as wireless communication systems, for example.

According to a further aspect embodiments also provide a decoder. The decoder comprises an LDPC decoder which is operable or configured to provide an output signal based on an input signal and based on an LDPC decoding rule corresponding to an $M'S \times N'S$ parity check matrix defining the LDPC code, with $M'S$ denoting the number of rows of the parity check matrix, $N'S$ denoting the number of columns of the parity check matrix, and $M'$, $N'$, $S$ denoting integer numbers, respectively. The parity check matrix comprises a plurality of (non-zero) $S \times S$ permutation (e.g., circulant) sub-matrices with an even number of non-zero (non-void) entries in each row of an $S \times S$ sub-matrix. Further, the decoder comprises a differential decoder which is operable or configured to provide a decoded signal based on the output signal from the LDPC decoder and based on a differential decoding rule.

According to some embodiments the decoder may serve for performing a corresponding decoding method comprising an act of LDPC decoding a received signal based on an LDPC decoding rule corresponding to an $M'S \times N'S$ parity check matrix comprising a plurality of $S \times S$ permutation (e.g., circulant) sub-matrices with an even number of non-zero (non-void) entries in each row of an $S \times S$ sub-matrix, and an act of differentially decoding the LDPC decoded received signal based on a differential decoding rule. Embodiments of the decoder may for example be comprised by an optical communications device, such as an optical receiver, which may comprise further receiver circuitry, such as mixers, Analog-to-Digital Converters (ADCs), demodulators, outer decoders, analog and/or digital signal processors, etc. Consequently, the received signal may have been transmitted via an optical communication channel, such an optical fiber, for example. However, it will be appreciated by the skilled person that embodiments may also be beneficial for other than optical communication systems, such as wireless communication systems, for example.

Hence, according to a further aspect, embodiments also provide a novel LDPC code design relying on an $M'S \times N'S$ parity check matrix having a plurality of (non-zero) $S \times S$ permutation (e.g., circulant) sub-matrices with an even number of non-zero (non-void) entries in each row of an $S \times S$ sub-matrix.

Some embodiments comprise digital circuitry installed within the encoders/decoders for performing the respective methods. Such a digital control circuitry, e.g., a digital signal processor (DSP), a Field-Programmable Gate Array (FPGA), an Application-Specific Integrated Circuit (ASIC), or a general purpose processor, needs to be programmed accordingly. Hence, yet further embodiments also provide a computer program having a program code for performing embodiments of the method, when the computer program is executed on a computer or a programmable hardware device.

Embodiments may help to improve the Signal-to-Noise Ratio (SNR) performance of optical transport systems while keeping the VLSI complexity low. Hence, embodiments may facilitate VLSI implementation and largely reduce implementation complexity.

Brief description of the Figures

Some embodiments of apparatuses and/or methods will be described in the following by way of example only, and with reference to the accompanying figures, in which

Fig. 1     schematically illustrates a signal processing chain of an optical communication system;

Fig. 2     illustrates an equivalent channel model with BPSK mapping phase and 180° phase slips;

Fig. 3     illustrates a block diagram of a conventional row-layered decoder with check node decoding operation;

Fig. 4     shows a detailed view of a row-layered decoder processing check node 5 of a code with
$\mathcal{N}(5) = \{1; 5; 9; 13; 21\}$;

Fig. 5     illustrates a pipelined implementation of the iterative differential decoding using trellis-based differential decoding;

Fig. 6     illustrates row-layered decoding and scattered memory access to the variable node aposteriori memory;

Fig. 7     illustrates hardware architecture (row decoding) for decoding quasi-cyclic LDPC codes;

Fig. 8     illustrates an embodiment with quasi-symmetric LDPC code and inter-changed roles of differential encoder and FEC decoder;

Fig. 9a    illustrates a performance evaluation for two different quasi-symmetric, quasi-cyclic codes with S=40 and S=80 and with bit-wise differential decoding (solid) or block-differential decoding (dashed);

Fig. 9b    shows a BER performance of the proposed quasi-symmetric code when compared to conventional schemes with an optimized irregular LDPC code and plain differential decoding or the iterative differential decoding with an optimized code for $P_{slip} = 10^{-7}$;

Fig. 10    illustrates a row decoding hardware architecture (simplified picture showing only one protograph connection) for the proposed quasi-symmetric LDPC codes;

Fig. 11    illustrates a 8-QAM modulation format with bit mapping such that only the first bit is subject to a phase slip and the remaining two bits are mapped rotationally invariant; and

Fig. 12    shows an embodiment with partially quasi-symmetric LDPC code and interchanged roles of differential encoder and FEC decoder for 8-QAM mapping.

Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

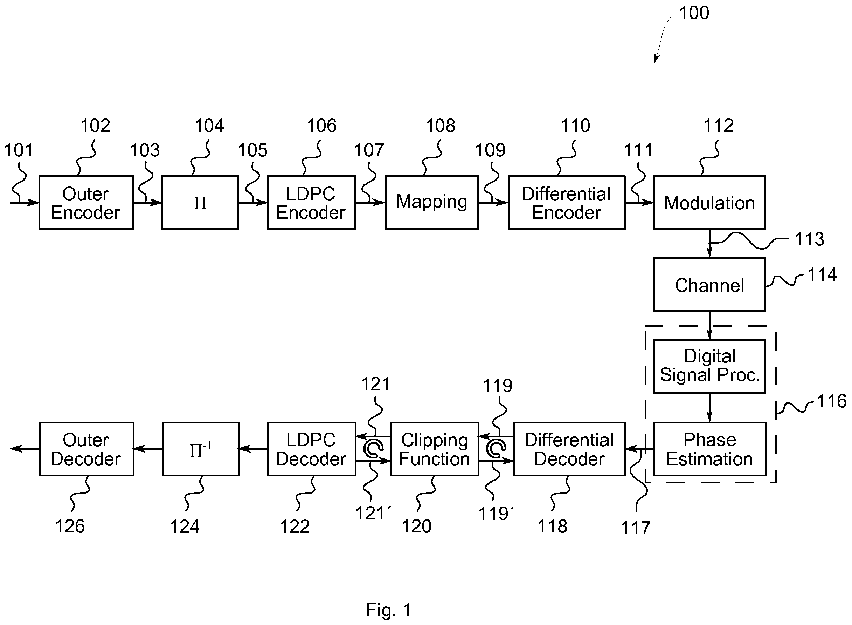

**Fig. 1** illustrates a communication system overview, which will be used subsequently to further detail and explain some embodiments.

Fig. 1 shows a signal processing chain of a communication system 100, e.g., an optical communication system, which can also be provided by embodiments. The signal processing exemplarily starts at the upper left corner of Fig. 1 with an outer encoder 102, which may, for example, correspond to a convolutional encoder, a Reed Solomon encoder, or a Turbo product encoder 102. The task of the outer encoder 102 is to add redundancy to an input information word 101, which may comprise digitized data. A signal output 103 of the outer encoder 102 may then be input into an interleaver 104, which interleaves the data. The interleaving can be adapted to an error characteristic, which is introduced in a transmission channel 114 later on such that burst errors can be resolved by subsequent de-interleaving 124 to enable enhanced error correction at an outer decoder 126. In the exemplary communication system 100 resulting interleaved data 105 may then be input into an LDPC encoder 106 to obtain (encoded) LPDC code words 107 before being assigned to transmission symbols 109 by a mapping entity 108. The transmission symbols 109 may then be differentially encoded by a differential encoder 110 to prevent or limit the effect of phase slips, which may occur due to undetectable phase noise events in the subsequent transmission channel 114. Strictly speaking, the phase slips do not occur in the transmission channel as such but are due to phase noise events that cause a phase offset correction algorithm to make a wrong decision. The phase noise correction algorithm is part of the digital signal processing chain that is not explicitly shown in Fig. 1 and that can be considered as being either part of the transmission channel 114 or as being part of the demodulation 116. Differentially encoded data symbols 111 may be derived, using a linear feedback shift register which comprises a delay element. The transfer function of the linear feedback shift register performing the differential encoding rule is given in the z-domain as $H(z) = 1/(1-z^{-1})$. In the BPSK case, the differential encoder 110 can be represented as an accumulator computing $y_i = y_{i-1} \oplus x_i$, where "$\oplus$" denotes the modulo-2 addition or the eXclusive OR (XOR) operation, respectively. The differentially encoded transmission symbols 111 are then modulated by modulator 112 and transmitted through the transmission channel 114. Note that the blocks 102 to 112 make up a transmitter of the communication system 100. This can be an optical transmitter.

The modulation 112 may comprise a conversion from base band, which can be complex, to a transmission band as well as a conversion from a digital/electrical to an optical signal. In the present example an optical conversion and thus an optical transmission channel 114 is assumed. In a transmission channel, e.g., an optical, a wireless, a wireline or a powerline transmission channel, phase slips can occur due to the inability of a receiver to handle large phase noise, i.e., the phase may jump or suddenly change by a certain angle. This angle may correspond to 180° or $\pi$ in a BPSK case; it may correspond predominantly to 90° or $\pi/2$ in the QPSK case. Such a phase slip may result in erroneous symbols being detected subsequently. The differential coding 110 limits the effect of a phase slip to the symbol, which is detected subsequent to the phase slip, as the difference to the previous symbol only is affected by the phase slip. However, since the difference to the next symbol is not affected by the phase slip (assuming only a single phase slip to occur), the differential encoding limits the effect of a phase slip. As the phenomenon of phase slips is well known in the art further details will be omitted not to obscure the principles of embodiments.

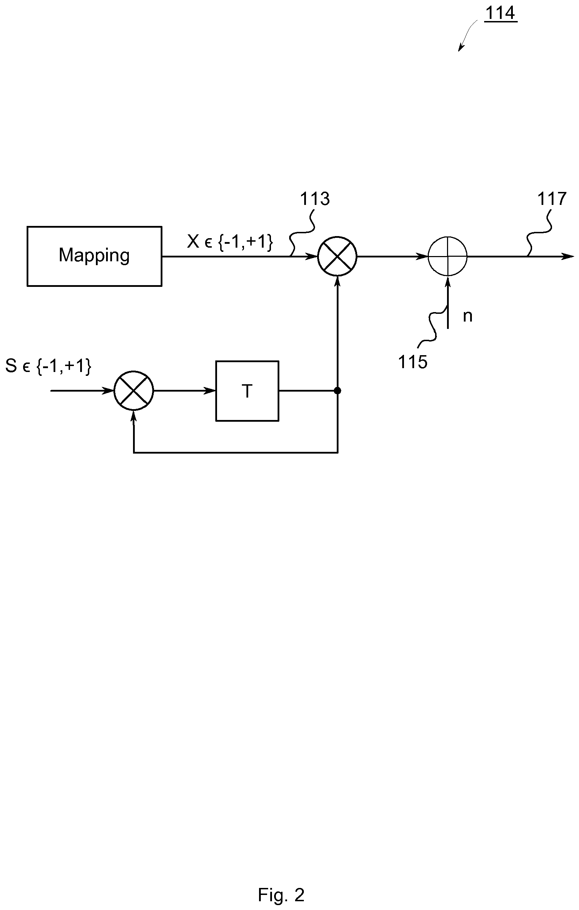

**Fig. 2** shows an equivalent channel model with BPSK mapping phase and 180° phase slips. Binary symbols $x \in \{-1, +1\}$ are transmitted via the channel 114 and are affected by additive noise $n$, 115. The occurrence of a phase slip is determined by a random variable $s$, which is Bernoulli distributed with $P(s = -1) = P_{slip} \ll 1$. Whenever $s = -1$, a phase slip is said to occur and from this time instant on, all consecutive transmitted symbols $x$ are flipped by their sign until the occurrence of the next phase slip. In the following we assume that the phase slips are rare and their probability of occurrence is low.

At the receiver the received differentially encoded data symbols, i.e., the differentially encoded the LPDC code words, may be demodulated 116, where the demodulation 116 may include optical/electrical conversion and conversion from the transmission band to the complex base band. Fig. 1 illustrates a processing path between the demodulation 116 and a subsequent de-interleaver 124 involving a differential decoder 118, an optional clipping function 120 and an LDPC decoder 122. Following the processing path, the base band symbols may be differentially decoded 118, which may result in soft information 119, i.e., information on estimated symbols or bits and reliability information thereon, which can, for example, be expressed in terms of likelihood values or log-likelihood values. This soft information 119 from the differential decoder 118 may also be denoted as extrinsic probability information. In the example shown in Fig. 1 a clipping function 120 may be applied to the output of the differential encoder. The clipping function 120 limits the likelihood values (extrinsic probability information) to enable a better decoding performance of the subsequent LDPC decoder 122.

The performance of the LDPC decoder 122 can be improved by the limitation as an upper limit of the likelihood values can be assumed based on a known occurrence or probability of occurrence of a phase slip. For example, the probability of a phase slip for a given optical channel may be in a range around $10^{-3}$. Hence, all likelihood values can be limited to $10g((1-10^{-3})/10^{-3}) \approx 6.91$, as this is the highest certainty that can be achieved. In other words, a residual error rate of $10^{-3}$ is known and considered by using an according the clipping function 120. This is only a simplified view. The clipping function 120 can be a pure clipping function that saturates all values above a certain threshold to that value or it can be a smooth function given by an equation $f(x) = \log(((1-P_s)\cdot\exp(x) + P_s)/(P_s\cdot\exp(x) + (1-P_s)))$, wherein $P_s$ denotes the probability of a phase slip.

The clipped output 121 of the clipping function 120 may then be input into the LDPC decoder 122, which will be explained in more detail below. The LDPC decoder 122 may then determine updated likelihood values 121', which may be fed back to the clipping function 120 and from there to the differential decoder 118 as priori probability information 119' for a next iteration of differential decoder 118, which is indicated by the arrows between the differential decoder 118, the clipping function 120, and the LDPC decoder 122. The circular shaped arrows indicate that a number of iterations may be carried out, wherein the likelihood values are updated by one of the decoders 118, 122 and clipped in between by the clipping function 120. The decoding iteration may be terminated by a parity check criterion. The output from the LDPC decoder 122 may then be de-interleaved by de-interleaver 124 before being provided to the outer decoder 126 for outer decoding in line with the above described outer encoding 102.

For a better understanding of embodiments of the present invention a short introduction to LDPC codes and some related decoding algorithms will be provided in the following. An LDPC code may be defined by a sparse binary parity check matrix **H** of dimension $M{\times}N$, where $N$ is the LDPC code word length (in bits) of the LDPC code and $M$ denotes the number of parity bits. The rows of a parity check matrix are parity checks on the code words of a code. That is, they show how linear combinations of certain digits of each code word equal zero. Usually, the number of information bits equals $M$-$N$. The design rate of the code amounts to $r = (N-M)/N$. The overhead of the code is defined as OH = $1/r$ - 1 = $M/(N-M)$. Sparse means that the number of 1s in **H** is small compared to the number of zero entries. Practical LDPC codes usually have a fraction of "1s" that is below 1% by several orders of magnitude.

We start by introducing some notation and terminology related to LDPC codes. Each column of the parity check matrix **H** corresponds to one bit of a Forward Error Correction (FEC) frame or LPDC code word. As LDPC codes can also be represented in a graphical structure called Tanner graph (which we will not introduce here), the columns of **H** and thus the FEC frame (LPDC code word) bits are sometimes also called variable nodes, referring to the graph-theoretic representation. Similarly, each row of **H** corresponds to a parity check equation and ideally defines a parity bit, if **H** has full rank. For example, the rank can be defined as the column rank. The column rank of a matrix **H** is the maximum number of linearly independent column vectors of **H**. Correspondingly, row rank of **H** is the maximum number of linearly independent row vectors of **H**. Owing to the Tanner graph representation, the rows of **H** are associated to so-called check nodes. Note that the row rank and the column rank of a matrix **H** are always equal, which is a well-known result in linear algebra.

In order to describe an exemplary LDPC decoder 122 we introduce some additional notation. First, we denote by **x** the vector of $K = N - M$ information bits. The single elements of **x** are denoted by $x_i$, i.e., $\mathbf{x} = (x_1, x_2, ..., x_i, ..., x_K)^T$. After encoding with an exemplary LDPC encoder 106, the LDPC code word 107 $\mathbf{y} = (y_1, y_2, ..., y_N)^T$ of length $N$ results. We denote by $y_i$ the single bits of the code word **y**. The LDPC code is said to be systematic if the information vector **x** is included in the code word, e.g., if $\mathbf{y} = (x_1,..., x_K, p_1, ... p_M)^T$, with $\mathbf{p} = (p_1, ..., p_M)^T$ denoting the vector of $M$ parity bits.

Furthermore, let the set $\mathcal{N}(m)$ denote the positions of the 1s in the $m$-th row of H, i.e., $\mathcal{N}(m) = \{i: H_{m,i} = 1\}$. A binary vector y is a code word of the LDPC code defined by **H**, if $\mathbf{Hy = 0}$, with the additions defined over the binary field (addition modulo-2, or XOR, respectively). The set of code words is thus defined to be the null space of **H**. This signifies

$$\sum_{j\in\mathcal{N}(m)} y_j = 0,$$

that the product of each row of **H** and **y** must be zero, or for all $m$ with $1 \le m \le M$.

Let us illustrate the concept of LDPC codes by a "toy" example. This example defines a parity check matrix **H** of two concatenated (4, 5) single parity check codes, separated by a $4{\times}5$ block-interleaver. The exemplary parity check matrix **H** of dimension $9{\times}25$ is given by

$$\mathbf{H} = \begin{pmatrix} 1 & 1 & 1 & 1 & & & & & & & & & & & & & & 1 & & & & & & & \\ & & & & 1 & 1 & 1 & 1 & & & & & & & & & & & 1 & & & & & & \\ & & & & & & & & 1 & 1 & 1 & 1 & & & & & & & & 1 & & & & & \\ & & & & & & & & & & & & 1 & 1 & 1 & 1 & & & & & 1 & & & & \\ 1 & & & & & 1 & & & & 1 & & & & 1 & & & & & & & & 1 & & & \\ & 1 & & & & & 1 & & & & 1 & & & & 1 & & & & & & & & 1 & & \\ & & 1 & & & & & 1 & & & & 1 & & & & 1 & & & & & & & & 1 & \\ & & & 1 & & & & & 1 & & & & 1 & & & & 1 & & & & & & & & 1 \\ & & & & & & & & & & & & & & & & 1 & 1 & 1 & 1 & & & & & 1 \end{pmatrix}.$$

Note that for simplicity reasons only the 1s are illustrated in the parity check matrix **H** above. Thus, $M = 9$, $N = 25$, and the code has an overhead of 56% (given by $M/(N - M)$) or a rate of $r = 0.64$, equivalently. We have

$$\mathcal{N}(1) = \{1; 2; 3; 4; 17\}, \quad \mathcal{N}(2) = \{5; 6; 7; 8; 18\}, \quad \mathcal{N}(3) = \{9; 10; 11; 12; 19\},$$

$$\mathcal{N}(4) = \{13; 14; 15; 16; 20\}, \quad \mathcal{N}(5) = \{1; 5; 9; 13; 21\}, \quad \mathcal{N}(6) = \{2; 6; 10; 14; 22\},$$

$$\mathcal{N}(7) = \{3; 7; 11; 15; 23\}, \quad \mathcal{N}(8) = \{4; 8; 12; 16; 24\}, \quad \mathcal{N}(9) = \{17; 18; 19; 20; 25\}.$$ This means for instance that we have (using the first row of **H**) $y_1+y_2+y_3+y_4+y_{17}=0$, or, if the code is systematic, $x_1+x_2+x_3+x_4+p_1=0$, i.e., $p_1=x_1+x_2+x_3+x_4$, defines the first parity bit.

One of the most common decoding algorithms for LDPC codes is the so-called "sum-product" decoding algorithm and its simplified versions. These algorithms can be described either in a graph structure commonly denoted Tanner graph, or given directly in a form suitable for implementation. While the former is advantageous for describing and understanding the underlying operations, we only focus on the latter in this specification.

In the context of coherent detection, we can usually assume an equivalent Additive White Gaussian Noise (AWGN) channel model for the transmission channel 114. This assumption is justified by the central limit theorem which applies due to the extensive use of filtering in inner Digital Signal Processing (DSP) stages of the transmitter and/or receiver. If we denote by $y_i$ ($i = 1, ..., N$) the single bits of an LDPC code word **y** as defined above, then the received values at the input of the LDPC decoder 122 after differential decoding 118 amount to $z_i = y_i + n_i$, with $n_i$ ($i = 1, ..., N$) being Gaussian distributed noise samples of zero mean and variance $\sigma^2$. Usually, the received noisy samples are converted into the Log-Likelihood Ratio (LLR) domain, which leads to a numerically more stable decoder implementation. The LLR of a received sample $z_i$ may be defined as

$$L(z_i) = \log\left(\frac{p(z_i \mid y_i = 0)}{p(z_i \mid y_i = 1)}\right) \tag{1}$$

with $p(z_i \mid y_i = k) = \exp\left(-(z_i - (1-2k))^2 /(2\sigma^2)\right)/\sqrt{2\pi\sigma^2}$ denoting the probability density function (pdf) of the received sample $z_i$ under AWGN assumption conditioned on the transmitted bit $y_i$ and with bipolar signaling ($y_i=0 \rightarrow +1$, $y_i=1 \rightarrow -1$). Conveniently, it turns out that $L(z_i) = z_i \cdot 2/\sigma^2 = z_i \cdot L_c$ under the AWGN assumption. Usually, the value $L_c = 2/\sigma^2$ is assumed to be constant and predetermined.

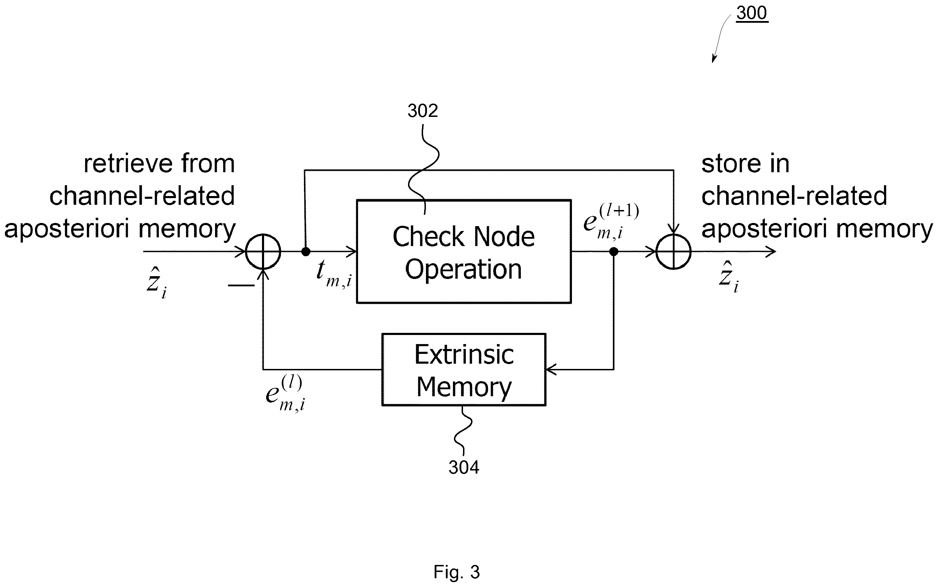

Turning now to Fig. 3, we describe a conventional row-layered LDPC decoding algorithm, as introduced in D. E. Hocevar, "A Reduced Complexity Decoder Architecture via Layered Decoding of LDPC Codes," in Proc. IEEE Workshop on Signal Processing Systems (SIPS), 2004. Here, the LDPC decoder continuously updates the received LLR values with the goal to compute LLRs that approximate the Maximum A Posteriori (MAP) values. The received vector of LLRs **z** 121 is therefore copied to a memory $\hat{\mathbf{z}}$ of size $N$, which is continuously updated. The decoding operation in the row-layered decoder 122 comprises three acts, where a) the first act prepares the input data, b) the second act performs the computation of new extrinsic data and c) the final act updates the LLR memory. The row-layered LDPC decoder 122 carries out the three steps sequentially for each row of the parity check matrix **H**. After all rows have been considered, a single decoding iteration has been carried out. The LDPC decoder usually carries out several iterations, where the number depends on the available resources.

In the following, we describe the aforementioned three acts for a single row $m$ of **H.** The first step a) comprises computing card $(\mathcal{N}(m)) = d_c$ (card = cardinality) temporary values $t_{m,i}$, with

$$t_{m,i} = \hat{z}_i - e_{m,i}^{(l)} \qquad \text{for all } i \in \mathcal{N}(m) \tag{2}$$

for all non-zero entries (indexed by $i$) of the $m$'th row **of H.** The superscript $(l)$ denotes the iteration counter, i.e., the operations are carried out in the $l$-th iteration of the row-layered LDPC decoding procedure. The value $e_{m,i}$ is the (stored) extrinsic memory for row $m$ and variable $\hat{z}_i$. At the beginning of the decoding of a single LDPC frame (code word), all $e_{m,i}$ may be initialized by zero (i.e., $e_{m,i}^{(1)} = 0$) and then continuously updated. Note that in total only $\sum_m \text{card}(\mathcal{N}(m))$ memory locations may be used for storing the $e_{m,i}$. If the code is check-regular, $\sum_m \text{card}(\mathcal{N}(m)) = Md_c$. In the second step, the extrinsic memory for the subsequent iteration $(l+1)$ is updated using the $t_{m,i}$ according to

$$
\begin{aligned}
e_{m,i}^{(l+1)} &= 2 \cdot \tanh^{-1}\left( \prod_{j \in \mathcal{N}(m)\backslash\{i\}} \tanh\left(\frac{t_{m,j}}{2}\right) \right) \qquad \text{for all } i \in \mathcal{N}(m) \\
&= \left[ \prod_{j \in \mathcal{N}(m)\backslash\{i\}} \text{sign}(t_{m,j}) \right] \cdot \phi\left( \sum_{j \in \mathcal{N}(m)\backslash\{i\}} \phi(|t_{m,j}|) \right), \quad \text{with } \phi(\tau) = -\log\left(\tanh\left(\frac{\tau}{2}\right)\right) = \log\left(\frac{e^\tau + 1}{e^\tau - 1}\right)
\end{aligned}
\tag{3}
$$

where the log-domain expression may be more suitable for practical implementations, as the multiplication is replaced by an addition and instead of two functions $\tanh(\cdot)/\tanh^{-1}(\cdot)$, only a single function $\phi(\cdot)$ needs to be implemented (or approximated by a look-up table). The product (or the sum) of equation (3) may be carried out over all entries in $\mathcal{N}(m)$ except the one under consideration $i$. This is indicated by the notation $\mathcal{N}(m)\backslash\{i\}$. For instance, in the above example, where $\mathcal{N}(5) = \{1; 5; 9; 13; 21\}$, $e_{5,13}^{(l+1)}$ may be computed corresponding to

$$
\begin{aligned}
e_{5,13}^{(l+1)} &= 2 \cdot \tanh^{-1}\left( \prod_{j \in \mathcal{N}(5)\backslash\{13\}} \tanh\left(\frac{t_{m,j}}{2}\right) \right) = 2 \cdot \tanh^{-1}\left( \prod_{j \in \{1;5;9;21\}} \tanh\left(\frac{t_{m,j}}{2}\right) \right) \\
&= 2 \cdot \tanh^{-1}\left( \tanh\left(\frac{t_{5,1}}{2}\right) \tanh\left(\frac{t_{5,5}}{2}\right) \tanh\left(\frac{t_{5,9}}{2}\right) \tanh\left(\frac{t_{5,21}}{2}\right) \right).
\end{aligned}
\tag{4}
$$

The derivation of equation (4) for the extrinsic update is beyond the scope of this specification. Usually, if high LDPC decoder throughputs shall be achieved, the computation of $e_{m,i}$ can be further simplified. An often employed simplification of the log-domain equation (3), which we will consider in the following, is the so-called min-sum approximation which leads to

$$e_{m,i}^{(l+1)} = \left[ \prod_{j \in \mathcal{N}(m)\backslash\{i\}} \text{sign}(t_{k,j}) \right] \min_{j \in \mathcal{N}(m)\backslash\{i\}} |t_{m,j}| \qquad \text{for all } i \in \mathcal{N}(m). \tag{5}$$

As this second act b) computes the output of the parity check node $m$ of the check node in the graphical representation of LDPC codes, it is frequently denoted by check node operation.

Finally, in the last decoding act c), the LLR memory may be updated corresponding to

$$\hat{z}_i = t_{m,i} + e_{m,i}^{(l+1)} \qquad \text{for all } i \in \mathcal{N}(m) \tag{6}$$

and the LDPC decoder 122 may continue with decoding row $m$+1 or, if $m = M$, restarts at $m = 1$ (next iteration). **Fig. 3** shows the simplified block diagram 300 of the check node decoding operation for computing $e_{m,i}^{(l+1)}$. As has been explained before, the check node operation 302 may be realized by equations (3) (log-domain) or (5) (min-sum domain).

The update act c) can be further simplified in actual implementations. Let $\mu_m^{[1]} = \min_{j \in \mathcal{N}(m)} |t_{m,j}|$ be the first minimum of the absolute value of all involved incoming messages $t_{m,j}$ at row $m$ and let $i_m^{[1]} = \arg \min_{j \in \mathcal{N}(m)} |t_{m,j}|$ be the position (i.e., the index) of this first minimum. Let furthermore $\mu_m^{[2]} = \min_{j \in \mathcal{N}(m) \setminus \{i_m^{[1]}\}} |t_{m,j}|$ be the second minimum (larger than the first minimum) of all incoming messages at row $m$. We further define $s_m = \prod_{j \in \mathcal{N}(m)} \text{sign}(t_{m,j})$. The output message can then be computed corresponding to

$$e_{m,i}^{(l+1)} = s_m \cdot \text{sign}(t_{m,i}) \cdot \begin{cases} \mu_m^{[1]} & \text{if } i \neq i_m^{[1]} \\ \mu_m^{[2]} & \text{if } i = i_m^{[1]} \end{cases}. \tag{7}$$

Thus, one burden for implementing the check node operation 302 for computing $e_{m,i}^{(l+1)}$ consists in finding the first and second minimum of the incoming messages together with the position of the first minimum. The memory requirements of this algorithm are $N$ memory cells for storing the (continuously updated) a-posteriori values $\hat{z}_i$. Additionally, the storing requirements of the extrinsic memory $e_{m,i}$ 304 amount to the total number of 1s in the parity check matrix **H,** however, due to the simplified implementation using the minimum approximation, the extrinsic memory 304 does not need to store all $d_c$ different values per row, but only the $d_c$ different signs, both minima $\mu_m^{[1]}$ and $\mu_m^{[2]}$, and the location index of the first minimum $i_m^{[1]}$. The values $e_{m,i}$ can then be computed on the fly as required.

As the min-sum algorithm is only an approximation to the full belief-propagation expression of equation (3), numerous attempts have been made to improve the performance of the min-sum algorithm. Two notable improvements are the normalized min-sum algorithm and the offset min-sum algorithm, see J. Chen, A. Dholakia, E. Eleftheriou, M. P. C. Fossorier, and X.-Y. Hu, "Reduced-Complexity Decoding of LDPC Codes," IEEE Transactions on Communications, vol. 53, no. 8, pp. 1288-1299, Aug 2005. The update rule of the offset min-sum algorithm reads

$$e_{m,i}^{(l+1)} = s_m \cdot \text{sign}(t_{m,i}) \cdot \begin{cases} \max(\mu_m^{[1]} - \beta, 0) & \text{if } i \neq i_m^{[1]} \\ \max(\mu_m^{[2]} - \beta, 0) & \text{if } i = i_m^{[1]} \end{cases}, \tag{8}$$

where the variable $\beta$ can either be constant and determined offline or be updated during decoding according to a predefined rule.

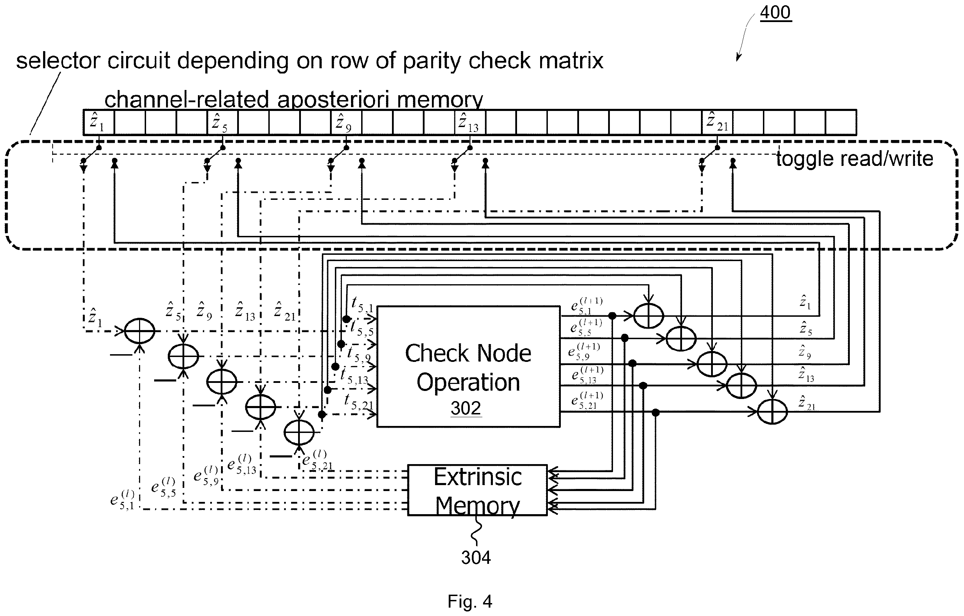

A simplified row-layered decoder block diagram 400, which can be derived from Fig. 3 in a straight forward way, is shown in **Fig. 4.** Thereby Fig. 4 exemplarily illustrates the check node operation for all entries in $\mathcal{N}(m)$, for example, $\mathcal{N}(5) = \{1; 5; 9; 13; 21\}$.

In order to recover the performance loss due to differential encoding, the LDPC decoder 122 can iteratively invoke the soft-input soft-output differential detector 118 as, e.g., described in EP 2 538 596 A1 or EP 2 506 516 A1. If a row-layered LDPC decoder is used, this has some implications on the architecture. The differential detector 118 may be implemented using the BCJR algorithm operating on a trellis diagram, see L. R. Bahl, J. Cocke, F. Jelinek, and J. Raviv, "Optimal Decoding of Linear Codes for minimizing symbol error rate", IEEE Transactions on Information Theory, vol. IT-20(2), pp.284-287, March 1974. In the remainder of this specification we employ the terms "trellis", "trellis decoder", "differential detector" synonymously. We can describe the trellis by a function $\mathbf{y} = f_T(\mathbf{s},\mathbf{a})$, with $\mathbf{s}$ denoting the vector of received modulation symbols from demodulator 116 and $\mathbf{a}$ denoting a-priori knowledge from the LDPC/FEC decoder 118, 122. The output of the trellis is so-called extrinsic information as defined in J. Hagenauer, E. Offer, L. Papke, "Iterative Decoding of Binary Block and Convolutional Codes", IEEE Trans. Inform. Theory, vol. 42, no. 2, March 1996.

Before first invoking the LDPC decoder 122, the differential detector 118 first needs to prepare the data and fill the LDPC decoder's a-posteriori memory $\hat{z}_i\ (i \in \mathcal{N}(m))$. This may initially be done by executing the trellis decoder 118 without a-priori knowledge: $\hat{z}_i = f_T(\mathbf{s},0)_i$ and by storing these initial values in a bypass memory 306, i.e.,

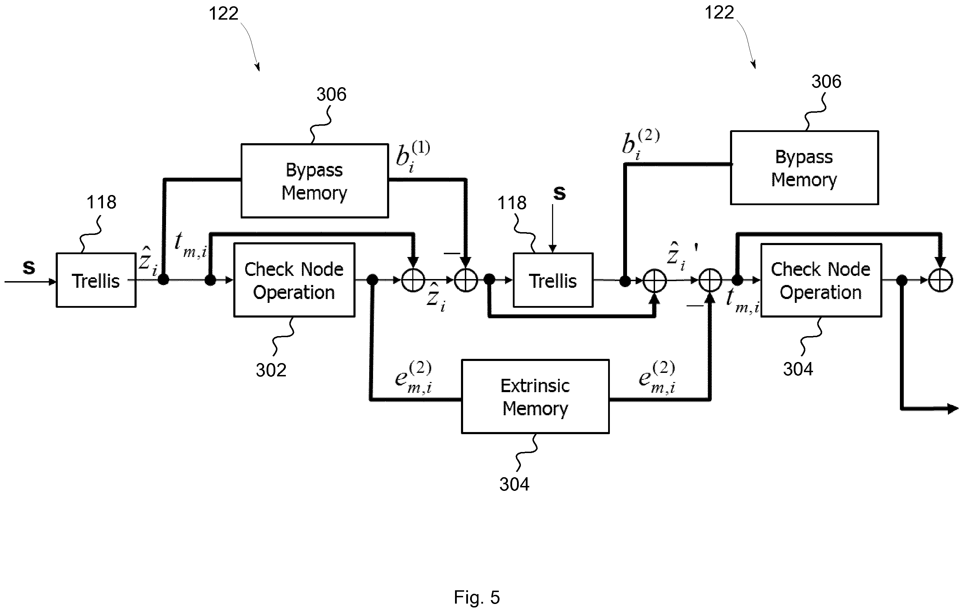

$$b_i^{(1)} = \hat{z}_i = f_T(\mathbf{s},0)_i \,,$$ **see Fig. 5.** Then the LDPC decoder 122 may be executed and the LDPC decoder's a-posteriori memory $\hat{z}_i$ may be updated several times during the execution of the LDPC decoder 122. Note that in the initial (first) iteration $e_{m,i}^{(1)} = 0$, i.e., the extrinsic memory 304 may be initialized to zero.

After executing the LDPC decoder 122, we now have updated values $\hat{z}_i$ in the LDPC decoder's a-posteriori memory, which is not shown in Fig. 5 for the sake of clarity. The input to the subsequent differential decoder stage 118 is obtained by subtracting the bypass memory $b_i$ 306 from the a-posteriori values $\hat{z}_i$. The next trellis output may be computed according to

$$b_i^{(2)} = f_T(\mathbf{s}, \hat{z}_i - b_i^{(1)})_i \,, \tag{9}$$

or more generally

$$b_i^{(l+1)} = f_T(\mathbf{s}, \hat{z}_i - b_i^{(l)})_i \,, \tag{10}$$

where $b$ denotes the extrinsic information computed by the trellis decoder 118 (see J. Hagenauer, E. Offer, L. Papke, "Iterative Decoding of Binary Block and Convolutional Codes", IEEE Trans. Inform. Theory, vol. 42, no. 2, March 1996). In order to get the updated a-posteriori value $\hat{z}_i'$, we may add the input of the trellis decoder 118 to its output, i.e., we get the updated a-posteriori value according to

$$\hat{z}_i' = \hat{z}_i - b_i^{(l)} + b_i^{(l+1)} = \hat{z}_i - b_i^{(l)} + f_T(\hat{z}_i - b_i^{(l)})_i \,. \tag{11}$$

Generally, in the case of LDPC codes, easy decoding algorithms exist and in contrast to classical channel coding, the challenge is not to find a good decoder for a given code, but to find a good code given the decoding algorithm. Most LDPC codes that are implemented today are so-called Quasi-Cyclic (QC) LDPC codes. They have a parity check matrix $\mathbf{H}$ with a structure that allows for inherent parallelization of the LDPC decoder and leads to an efficient encoder realization. Almost all LDPC codes utilized in practice belong to the class of QC LDPC codes.

QC-LDPC codes may be constructed using a so-called lifting matrix $\mathbf{A}$. The parity check matrix $\mathbf{H}$ may be constructed from the lifting matrix $\mathbf{A}$ by replacing each element of $\mathbf{A}$ with either an all-zero matrix of size $S \times S$ or a permutation matrix, e.g., a cyclically permuted identity matrix, of size $S \times S$. We adhere to the following notation: $S$ denotes the lifting factor, i.e., the size of the all-zero or cyclically shifted identity matrix. If the entry of $\mathbf{A}$ at row $m$ and column $i$ corresponds to a predetermined value, e.g., $A_{m,i} = -1$, then the all-zero matrix of size $S \times S$ is used, and if $A_{m,i} \geq 0$, $A_{m,i}$ may denote how many cyclic right shifts of the identity matrix are performed. If dim($\mathbf{H}$) = $M \times N$, then dim($\mathbf{A}$) = $M' \times N'$, with $M'=M/S$ and $N'=N/S$. We furthermore define the set $\mathcal{N}_{\mathbf{A}}(m)$ to denote the positions of the non "-1" entries (or any other entry denoting a void replacement) in the $m$-th row of A, i.e., $\mathcal{N}_{\mathbf{A}}(m) = \{i: A_{m,i} \neq -1\}$.

Let us illustrate the construction of QC-LDPC codes by a small (artificial) example with a lifting matrix of size dim($\mathbf{A}$) = $3 \times 5$ and a lifting factor of $S = 5$ (leading to dim($\mathbf{H}$) = $S \cdot$dim($\mathbf{A}$) = $15 \times 25$). This corresponds to a code of design rate $r = 0.4$, or an overhead of 150%, respectively).

$$\mathbf{A} = \begin{pmatrix} -1 & 0 & 1 & 1 & 2 \\ 2 & -1 & 4 & 2 & 1 \\ 1 & 3 & -1 & 3 & 1 \end{pmatrix} \rightarrow \mathbf{H} = \begin{pmatrix} & & & & & & & \\ & & & & & & & \end{pmatrix}$$

(12)

Note that for the sake of clarity again only the 1s are show in the description **of H.** Generally the value $S$ corresponds to the parallelism that can be implemented in a QC-LDPC decoder 122.

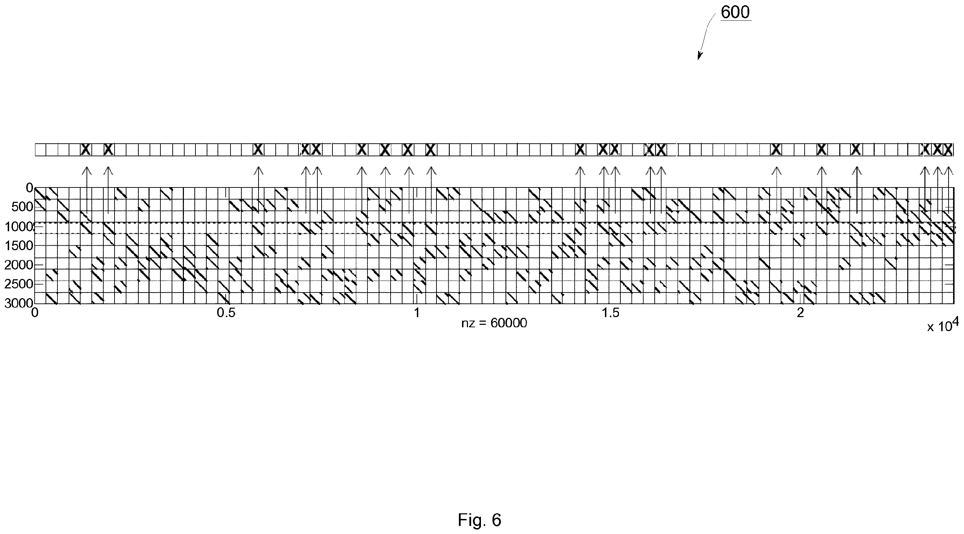

**Fig. 6** illustrates an example of a quasi-cyclic parity check matrix **H** (reference numeral 600) of size $3000 \times 25200$ ($M = 3000$, $N = 25200$) resulting from a lifting matrix **A** of size dim(**A**) = $10 \times 84$ with a lifting factor $S = 300$. Note that in this case, also **A** is sparse, i.e., most entries of **A** are, e.g., -1, leading to zero entries for **H.** Note that in Fig. 6 the 1s of **H** are shown as small points. Due to the cyclic structure of the matrix **H,** these show up as diagonal lines in Fig.6.

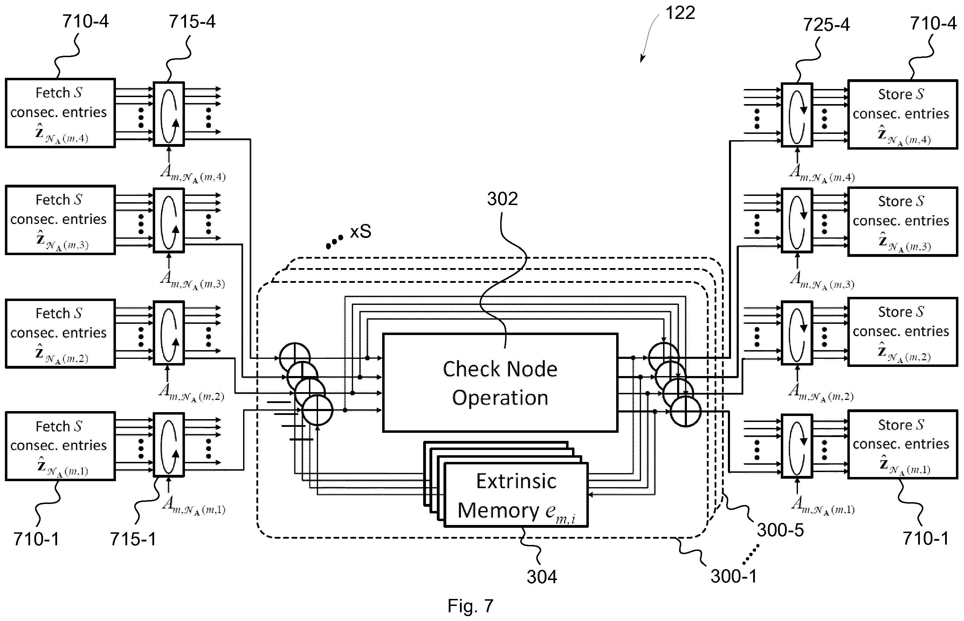

The implications of the quasi-cyclic (QC) code construction on the row-layered LDPC decoder is shown in **Fig. 7.** Due to the QC structure of **H,** a row-layered LDPC decoder 122 can now process always $S$ rows of **H** in parallel as these computations are independent. This parallelism is necessary to be able to operate at decoding speeds of 100Gbit/s and above. Instead of decoding each row of **H,** the row-layered decoder 122 for QC LDPC codes does now decode each row of the lifting matrix **A** by decoding $S$ rows **of H** in parallel.

The decoding circuitry set up for decoding the first row of **A** of the example above is shown in Fig. 7. Decoding the first row of **A** corresponds to decoding the first, e.g., $S = 5$ rows of **H.** Note that $S = 5$ in this example, such that $S = 5$ check node decoding circuits 300-1 to 300-5 can be deployed in parallel. Note that the first row of **A** contains only 4 non-void entries ($A_{m,i} \geq 0$, as does any other row), which means that each of the first 5 rows of **H** contains only 4 ones. In the left part of the circuit 122 shown in Fig. 7, the memory fetching circuits 710 each retrieve $S = 5$ neighboring values $\hat{z}_i$ of the a-posteriori memory. For example, the fetching circuit 710-1 retrieves the vector $\hat{\mathbf{z}}_{6:10} = (\hat{z}_6\ \hat{z}_7\ \hat{z}_8\ \hat{z}_9\ \hat{z}_{10})^T$ where the notation "6:10" denotes the entries 6 to 10. These are then processed by the shifting circuit 715-1 (which can be realized using a barrel shifter) to account for the cyclic shifting nature of **H.** If we consider the fetch circuit 710-4 which retrieves $\hat{\mathbf{z}}_{21:25} = (\hat{z}_{21}\ \hat{z}_{22}\ \hat{z}_{23}\ \hat{z}_{24}\ \hat{z}_{25})^T$, the corresponding entry of **A** is $A_{1,5} = 2$, which means that the shifter 715-4 is configured such that it performs a (cyclic) left-shift by "2" and the output of the shifter 715-4 is the vector $(\hat{z}_{23}\ \hat{z}_{24}\ \hat{z}_{25}\ \hat{z}_{21}\ \hat{z}_{22})^T$. The individual outputs of the shifters 715 are then fed to check node operations 302 as described above, and the outputs of the $S = 5$ parallel check node circuits 300-$s$ ($s = 1 \dots S$) are gathered and then fed to a bank of four inverse shifters 725, that are configured using the same values but perform cyclic right-shifts of the $S$ values at their inputs. These are then stored again in the a-posteriori memory 710.

Note that the columns of **H** correspond to the transmitted bits and the rows to the parity check equations. We assume that the all-zero code word **y** of 25 bits has been transmitted. Now assume that two phase slip have occurred at positions 6 and 16, leading to a received (hard decision) code word of **y'** = (0 0 0 0 0 1 1 1 1 1 1 1 1 1 1 00000 0 0 0 0 0)$^T$. Therefore, due to the slip, 10 consecutive bits have been flipped. If we now consider the evaluation of the parity check equations **H·y'**, we see that the first 5 parity equations are fulfilled, as both inverted bits are included in each of this five parity checks. However, the other 10 parity checks are not fulfilled due to the phase slip.

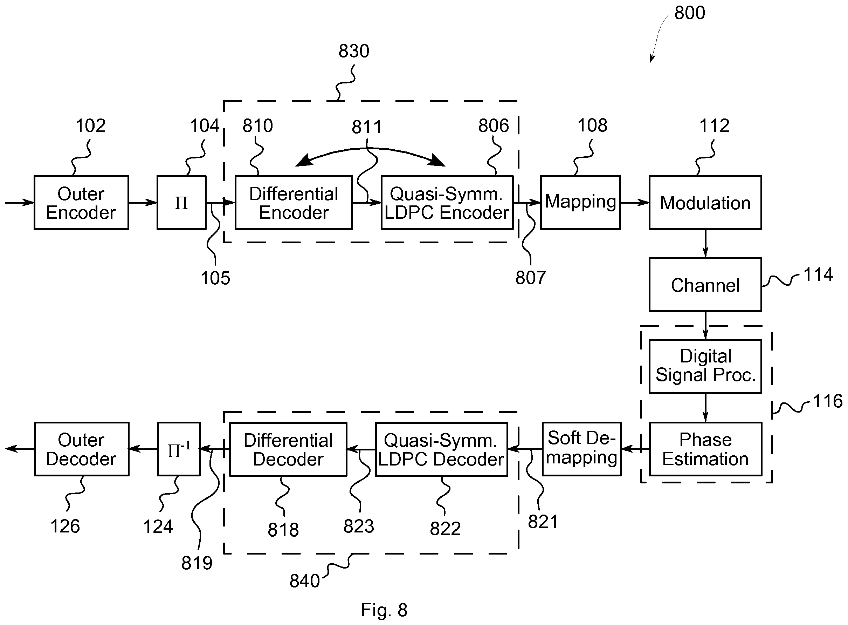

Embodiments of the present invention suggest a novel LDPC code design which also leads to fulfilled parity check equations for LDPC code word **y'** affected by a phase slip. For this purpose embodiments provide an LDPC encoder which is operable or configured to provide an LDPC encoded signal based on an LDPC encoding rule corresponding to an $M'S \times N'S$ parity check matrix **H'** which comprises a plurality of $S \times S$ permutation (e.g., circulant) sub-matrices with an even number of non-zero entries in each row (and thus, consequently, also with an even number of non-zero entries in each column) of a sub-matrix. As will be shown, the non-zero entries may be defined over the binary field $F_2$ or over the ring of integer numbers modulo 4. This LDPC encoder may be concatenated with a differential encoder, wherein the differential decoder is located upstream to (i.e., before) the LDPC encoder - in contrast to Fig. 1, where the differential decoder is located downstream to (i.e., after) the LDPC encoder. This will be explained in more detail with reference to Fig. 8.

For further illustration of embodiments let us consider the following code construction which may be denoted as Quasi-Symmetric Quasi-Cyclic (QCQS) LDPC code. A parity check matrix **H'** of a QCQS LDPC code may be obtained by adding parity check matrices **H₁** and **H₂** of two or more (an even number of) quasi-cyclic LDPC codes obtained based on associated two or more (an even number of) lifting matrices **A₁** and **A₂**. That is to say, the parity check matrix **H'** may correspond to an addition of an even number of parity check matrices corresponding to different quasi-cyclic LDPC codes, respectively. A first $M'S \times N'S$ parity check matrix **H₁** of the even number of parity check matrices may be constructed from a first $M' \times N'$ lifting matrix **A₁** by replacing each entry of the first lifting matrix **A₁** with either an all-zero matrix of size $S \times S$ or a permutation matrix, e.g., a cyclically permuted identity matrix, of size $S \times S$, depending on the entry of the first lifting matrix **A₁**. A second $M'S \times N'S$ parity check matrix **H₂** of the even number of parity check matrices may be constructed from a second $M' \times N'$ lifting matrix **A₂** by replacing each entry of the second lifting matrix **A₂** with either an all-zero matrix of size $S \times S$ or a permutation matrix, e.g., a cyclically permuted identity matrix, of size $S \times S$, depending on the entry of the second lifting matrix **A₂**. If the entry of **A₁**, **A₂** at row $m$ and column $i$ corresponds to a predetermined value, e.g., $A_{m,i} = -1$, then the all-zero matrix of size $S \times S$ is used, and if $A_{m,i} \geq 0$, $A_{m,i}$ may denote how many cyclic right shifts of the identity matrix are performed.

According to some embodiments the at least two lifting matrices **A₁** and **A₂** may have the property that no two entries (different from, e.g., -1 where "-1" denotes the entropy leading to a void replacement) at the same position are identical, i.e., $A_{1,m,i} = A_{2,m,i}$ if $A_{1,m,i} = -1$ and $A_{1,m,i} \neq A_{2,m,i} \neq -1$ if $A_{1,m,i} \neq -1$. We may furthermore assume without loss of generality that $A_{2,m,i} > A_{1,m,i}$ if $A_{1,m,i} \neq -1$. That is to say, an entry $A_{1,m,i}$ of the $m$-th row and the $i$-th column of the first lifting matrix **A₁** may correspond to an entry $A_{2,m,i}$ of the m-th row and the $i$-th column of the second lifting matrix **A₂** if the entry $A_{1,m,i}$ is $x$, wherein $x$ (e.g., $x = -1$) denotes a predetermined value of the first lifting matrix **A₁** leading to $S \times S$ void or zero entries in the corresponding first parity check matrix **H₁**, and wherein an entry $A_{1,m,i} \neq A_{2,m,i} \neq x$ if $A_{1,m,i} \neq x$. Further, $A_{1,m,i}$ may be smaller than $A_{2,m,i}$ if $A_{1,m,i} \neq x$.

Consider the following "toy" example:

$$\mathbf{A}_1 = \begin{pmatrix} -1 & 0 & 1 & 0 & 0 \\ 2 & -1 & 1 & 1 & 1 \\ 1 & 0 & -1 & 2 & 1 \end{pmatrix}$$

$$\mathbf{A}_2 = \begin{pmatrix} -1 & 2 & 4 & 1 & 2 \\ 3 & -1 & 4 & 2 & 4 \\ 3 & 3 & -1 & 3 & 3 \end{pmatrix} \rightarrow \mathbf{H'} =$$

$$(13)$$

The resulting parity check matrix **H'** has a dimension of $M' S \times N' S$ and comprises, besides a few $S \times S$ all-zero matrices (corresponding to the "-1" positions of the lifting matrices), a plurality of $S \times S$ permutation or circulant sub-matrices with two non-zero entries (e.g., ones) in each row of each $S \times S$ non-zero sub-matrix. In the above example each non-zero matrix is an $S \times S$ circulant sub-matrix with two non-zero entries (e.g., ones) in each row of each $S \times S$ non-zero sub-matrix. Further, $S = 5$ in the above example. Note that embodiments also allow four, six, eight, etc., non-zero entries (e.g., ones) in each row of each $S \times S$ non-zero sub-matrix.

If we receive the code word **y'** = (0 0 0 0 0 1 1 1 1 1 1 1 1 1 1 00000 0 0 0 0 0)$^T$ with 10 flipped bits at positions 6-15 due to phase slips, all parity check equations **H'·y'** are now fulfilled, as **y'** is a valid code word of the above QCQS LDPC code. This code has the property that all $2^{N'-1}$ possible received words due to phase slips at positions $1+S\cdot k$ ($k \in \{0, 1, 2,...., N'-2\}$), including the received word without any phase slip, form valid code words. As mentioned before we call such a code a Quasi-Cyclic, Quasi-Symmetric Low-Density Parity-Check (QCQS LDPC) code, in view of the family of asymmetric LDPC codes as defined in A. Scherb and K.-D. Kammeyer, "Non-coherent LDPC decoding on graphs", Proc. IEEE Information Theory Workshop (ITW), Chengdu, China, Oct. 2006. A symmetric LDPC code has the property that the binary inverse of every code word also forms a valid code word. Let $C = \{\mathbf{x} \in \{0;1\}^N \mid \mathbf{Hx}^T = \mathbf{0}\}$ be the code. The code is symmetric if $\mathbf{x}_1 = (1, 1, ..., 1)^T \in C$, which can be translated to the condition that rows of $\mathbf{H}$ have an even number of ones, see A. Scherb and K.-D. Kammeyer, "Non-coherent LDPC decoding on graphs", Proc. IEEE Information Theory Workshop (ITW), Chengdu, China, Oct. 2006. A quasi-symmetric (QS) code has the property that for every chunk $\mathbf{x}_c = (x_{(c-1)S+1}, ..., x_{cS})^T$ of a code word $\mathbf{x} = (\mathbf{x}_1{}^T, ..., \mathbf{x}_{c-1}{}^T, \mathbf{x}_c{}^T, \mathbf{x}_{c+1}{}^T, \mathbf{x}_{N'}{}^T)^T$ of $C$, the code word $\mathbf{x}'' = (\mathbf{x}_1{}^T, ..., \mathbf{x}_{c-1}{}^T, (\mathbf{x}_c \oplus \mathbf{1})^T, \mathbf{x}_{c+1}{}^T, \mathbf{x}_{N'}{}^T)^T$ (with $\oplus$ denoting the modulo-2 or XOR operation, respectively) also forms a valid code word, for every $c \in [1;N']$ and every collection of c's.

As with the above exemplary QCQS LDPC code according to an embodiment defined by **H'**, a corresponding LDPC decoder treats $\mathbf{y}' = (0\ 0\ 0\ 0\ 0\ 1\ 1\ 1\ 1\ 1\ 1\ 1\ 1\ 1\ 1\ 0\ 0\ 0\ 0\ 0\ 0\ 0\ 0\ 0\ 0)^T$ as a valid code word and may not perform any further corrections. Hence, we are still left after LDPC decoding with the problem that 10 bit errors remain after LDPC decoding. Generally, a string of $U$ erroneous bits is obtained after LDPC decoding with this code defined by **H'** if phase slips occurred at a distance of $U$ bits (with $U$ being a multiple of $S$). The original bit stream can be largely recovered if it is assumed that the bits at the input of the LDPC decoder have been differentially encoded. After corresponding differential decoding (downstream to the LDPC decoder), we get $\mathbf{y}'' = (0\ 0\ 0\ 0\ 0\ 10000\ 0\ 0\ 0\ 0\ 0\ 10000\ 0\ 0\ 0\ 0\ 0)^T$, i.e., we are left with two bit errors, one for each phase slip. Thus, if the phase slips occur at exactly boundaries defined by adjacent entries of a lifting matrix **A**, each phase slip may be translated into a bit error after differential decoding.

This leads to the proposed block diagram shown in **Fig. 8,** where we have swapped the positions of the differential code and the inner FEC (LDPC encoder) and where we use a modified LDPC encoder 806 and decoder 822 making use of embodiments of the QCQS LDPC code construction shown above. Hence, some embodiments suggest an encoder 830 to be used on transmitter side, wherein the encoder 830 comprises a differential encoder 810 which is configured to provide a differentially encoded signal 811 based on an input signal 105 and based on a differential encoding rule. Thereby the differential encoder 810 can be a plain bit differential encoder making a current bit to depend on a previous bit or a block differential encoder making a current block of bits to depend on a previous block of bits, resulting in a lower complexity. Further, the encoder 830 comprises an LDPC encoder 806 which is configured to provide an LDPC encoded signal 807 based on the differentially encoded signal 811 and based on an LDPC encoding rule defined by or corresponding to an $M'S \times N'S$ parity check matrix **H'** comprising a plurality of $S \times S$ permutation or circulant sub-matrices with an even number of non-zero entries in each row of a sub-matrix. In this way the LDPC decoding rule may be kept transparent to phase slips caused by noise of a transmission channel for the LDPC encoded signal.

On the receiver side some embodiments provide a decoder 840 comprising an LDPC decoder 822 which is configured to provide an output signal 823 based on an input signal 821 and based on an LDPC decoding rule defined by or corresponding to an $M'S \times N'S$ parity check matrix **H'** comprising a plurality of $S \times S$ permutation or circulant sub-matrices with an even number of non-zero entries in each row of an $S \times S$ sub-matrix. Further, the decoder 840 comprises a differential decoder 818 which is configured to provide a decoded signal 819 based on the output signal 823 from the LDPC decoder 822 and based on a differential decoding rule corresponding to the differential encoding rule.

As has been explained before, the encoder 830 and/or decoder 840 may be comprised by an optical communication system 800 for transmitting optical signals. However, other applications, such as in wireless communications, are also possible. Therefore embodiments are not restricted to the exemplary setup shown in Fig. 8. In fact, other hard- and/or software combinations are possible.

Note that exemplary LDPC code constructions according to embodiments may lead to rank-deficient LDPC parity check matrices **H'.** One can see from the above example that there are at least $M'$ linearly dependent parity check equations (if we consider the S parity check equations corresponding to one line (row) of $\mathbf{A}_i$, we see that the rank of that sub-matrix is upper bounded by $S$-1). This means that the total or combined parity check matrix **H'** is rank-deficient with rank(**H'**) $\leq M'(S$-1). This in turn means that from the $M'S$ parity bits generated by the encoder 806, $M'$ are linearly dependent parity checks. This increase in coding rate may be avoided especially in optical communication systems, which already operate at very high rates close to the theoretical limits.

Some embodiments therefore allow to construct LDPC codes without the described rank deficiency, i.e., with rank(**H'**) $\leq M'S$. One possibility to get a full-rank LDPC parity check matrix is to have for instance in each chunk of $S$ rows of **H'** one $S \times S$ sub-matrix which has an even number of additional non-zero entries, such that there are, e.g., 4 ones in this row of the $S \times S$ sub-matrix. Another possibility is to remove in each chunk of $S$ rows of **H'** and in one row of one $S \times S$ sub-matrix of said chunk an even number of the non-zero entries. That is to say, regarding a parity check matrix **H'** comprising $M$ chunks of S rows, wherein $M$ denotes a number of rows of an associated lifting matrix $\mathbf{A}_1$ and/or $\mathbf{A}_2$ of the parity check matrix **H',** each chunk of $S$ rows comprises one row with more or less non-void or non-zero entries than the other rows of said chunk, such that the parity check matrix **H'** has full rank. In this case the resulting LDPC code is not quasi-cyclic (QC) anymore, but the quasi-symmetric (QS) property is maintained.

An exemplary LDPC parity check matrix according to the first possibility, i.e., each chunk of $S$ rows comprises one row with more non-zero entries than the other rows of said chunk, is given by

$$\mathbf{H''}=\begin{pmatrix} & & & & & & & & & & \\ & & & & & & & & & & \\ & & & & & & & & & & \\ & & & & & & & & & & \\ & & & & & & & & & & \\ \end{pmatrix},$$

(14)

wherein the added 1s are given in a larger font size. An exemplary parity check matrix according to the second possibility, i.e., each chunk of $S$ rows comprises one row with less non-zero entries than the other rows of said chunk, is given by

$$\mathbf{H'''}=\begin{pmatrix} & & & & & & & & & & \\ & & & & & & & & & & \\ & & & & & & & & & & \\ & & & & & & & & & & \\ & & & & & & & & & & \\ \end{pmatrix}.$$

(15)

Of course corresponding LDPC decoding platforms 822 need to be adapted accordingly if one of these modifications is implemented.

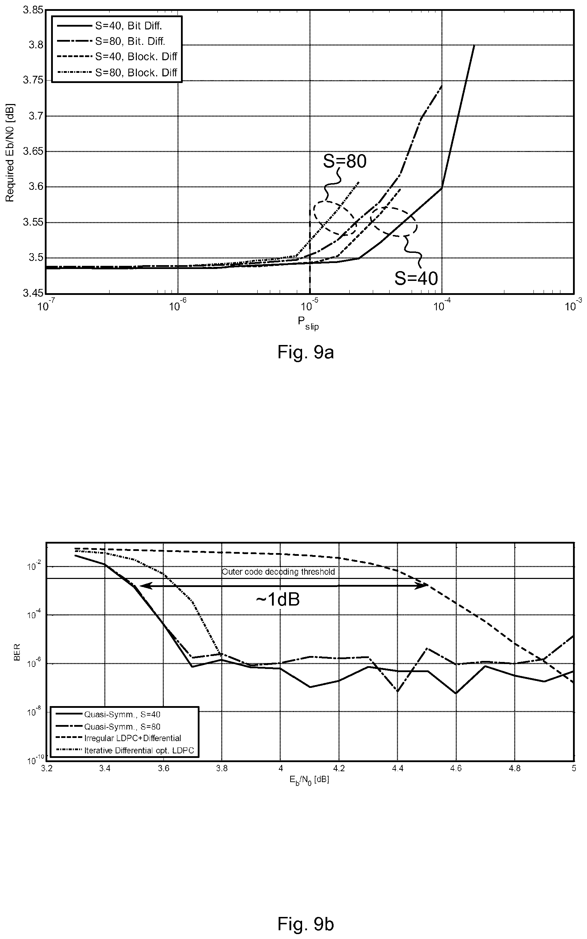

The performance of communication systems 800 according to embodiments is compared with conventional communication systems 100 in **Figs. 9a and 9b.** We compare the performance using two different LDPC codes $C_1$ and $C_2$ with the following properties

- Code $C_1$:

  ∘ $S = 40$, $M'$=80, $N'$=600,
  ∘ leading to dim$\mathbf{H} = M \times N = SM' \times SN'$=3200×24000, rank($\mathbf{H}$)=3120

- Code $C_2$:

  ∘ $S = 80$, $M'$=40, $N'$=300,
  ∘ leading to dim$\mathbf{H} = M \times N = SM' \times SN'$=3200×24000, rank($\mathbf{H}$)=3160.

The LDPC codes $C_1$ and $C_2$ have been combined with a bit differential code and with a block differential code, respectively. We can see from the Fig. 9a that embodiments work especially well for phase slip probabilities < $10^{-5}$. If we fix $P_{slip} = 10^{-7}$ (see Fig. 9b), we see that we can even outperform the system described in EP 2 538 596 A1 which uses a dedicated optimized code with a significantly lower decoding complexity. If we compare with a system of approximately identical decoding complexity which is composed of a simple differential decoder and an optimized LDPC code, we can achieve a performance gain of about 1dB, see Fig. 9b. We assume that the outer code 102 is a 7% overhead code as specified in ITU-T, G.975.1 "Forward Error Correction for high bit-rate DWDM submarine systems", 2004, which requires an input BER of around $3 \cdot 10^{-3}$ to achieve near error-free decoding.

As has already been described above, the decoding operation in a row-layered LDPC decoder for QC-LDPC codes with a parity check matrix generated by a lifting operation from a lifting matrix **A**, comprises three acts, where a first act a) prepares the input data, a second act b) performs the computation of new extrinsic data and a final act c) updates the LLR memory. The LDPC decoder carries out the three steps sequentially for each row of the LDPC parity check matrix. After all rows have been considered, a single decoding iteration has been carried out. The decoder usually carries out several iterations, where the number depends on the available resources. Let the set $\mathcal{N}_{\mathbf{A}}(m)$ denote the positions of the non-"-1" entries in the $m$-th row of **A** (or any other entry denoting a void replacement), e.g.,

$$\mathcal{N}_{\mathbf{A}}(m) = \{i: A_{m,i} \neq -1\},$$ if $x$ = -1. In the following, we describe the three acts for a single row $m$ of **A** for the case of QC-LDPC codes.

The first LDPC decoding act comprises computing $S \cdot \mathrm{card}(\mathcal{N}_{\mathbf{A}}(m)) = S \cdot d_c$ temporary values $t_{m,i,s}$, with

$$t_{m,i,s} = f_{\mathrm{shift},s}(\hat{\mathbf{z}}_i, A_{m,i}) - e_{m,i,s} \qquad \text{for all } i \in \mathcal{N}_{\mathbf{A}}(m) \text{ and } s \in [1; S]$$

$$(16)$$

for all non-zero entries (indexed by $i$) of the $m$-th row of **A**. The function $f_{\mathrm{shift},s}(\mathbf{z}, A_{m,i})$ returns the $s$-th entry after cyclically left-shifting the vector **z** by $A_{m,i}$ positions. The value $e_{m,i,s}$ denotes the (stored) extrinsic memory for row $m$ of **A** and variable $\hat{z}_{i,s}$. At the beginning of the decoding of a single LDPC frame (code word), all $e_{m,i,s}$ may be initialized by zero and then continuously updated. Note that in total $S \cdot \sum_m \mathrm{card}(\mathcal{N}_{\mathbf{A}}(m))$ memory locations may be required for storing the extrinsic values $e_{m,i,s}$. If the code is check-regular, $S \sum_m \mathrm{card}(\mathcal{N}_{\mathbf{A}}(m)) = S \cdot M \cdot d_c$.

In the second LDPC decoding act, the extrinsic memory may be updated using the temporary values $t_{m,i,s}$ corresponding to

$$e_{m,i,s} = \left[ \prod_{j \in \mathcal{N}_{\mathbf{A}}(m) \backslash \{i\}} \mathrm{sign}(t_{k,j,s}) \right] \min_{j \in \mathcal{N}_{\mathbf{A}}(m) \backslash \{i\}} | t_{m,j,s} | , \text{ for all } i \in \mathcal{N}_{\mathbf{A}}(m) \text{ and } s \in [1; S] \quad (17)$$

Equation (17) denotes the aforementioned min-sum update. Note that there exist different varieties for this update equations, namely the sum-product rule, the box-plus update rule, the scaled min-sum update rule or the offset-corrected update rule, to name only a few. A comprehensive overview is given in W.E. Ryan and S. Lin, Channel Codes - Classical and Modern, Cambridge University Press, 2009. As this second LDPC decoding act computes the output of the parity check node of the check node in the graphical representation of LDPC codes, it is frequently denoted by check node operation.

In a further LDPC decoding act, the LLR memory may be updated corresponding to

$$\widetilde{z}_{i,s} = t_{m,i,s} + e_{m,i,s} \qquad \text{for all } i \in \mathcal{N}_{\mathbf{A}}(m) \text{ and } s \in [1; S]$$

$$(18)$$

and

$$\hat{\mathbf{z}}_i = f_{\text{shift}}^{-1}\left(\widetilde{z}_{i,1},\ldots,\widetilde{z}_{i,S},A_{m,i}\right).\qquad(19)$$

Then the LDPC decoder may continue with decoding row $m$+1 or, if $m = M$ of $\mathbf{A}$, or may restart at $m$=1 (next iteration). Fig. 7 shows the simplified block diagram of the check node decoding operation for $\text{card}(\mathscr{N}_{\mathbf{A}}(m)) = 4$ (i.e., $\mathbf{A}$ contains four non-void entries at row $m$). Due to the fact that the code is quasi-cyclic, always S consecutive rows of $\mathbf{H}$ (one row of $\mathbf{A}$) can be computed in parallel.

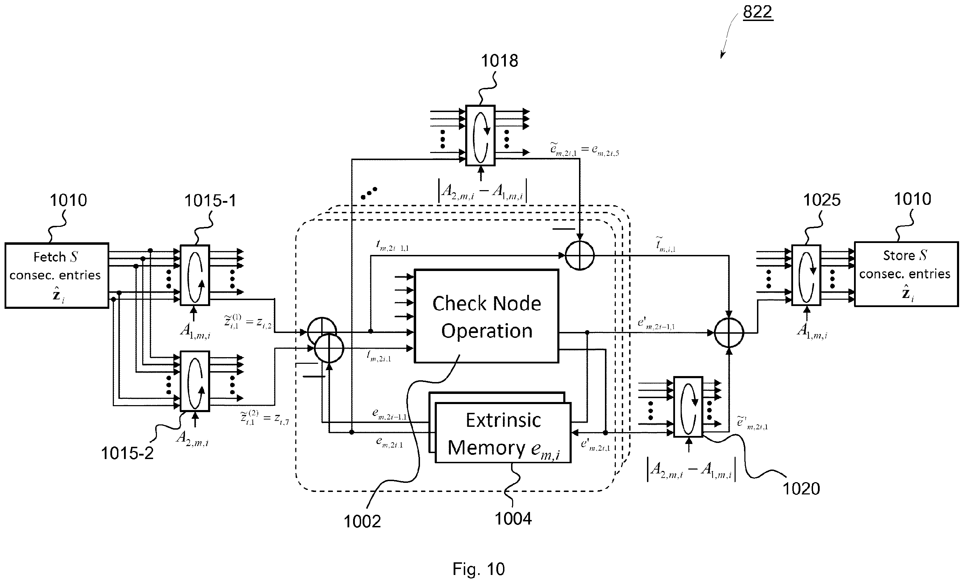

In contrast the conventional row-layered decoder for QC LDPC codes, we may modify the LDPC decoder 822 slightly for the QCQS LDPC codes according to embodiments. This is due to the fact that in each block of $S\times S$ entries in $\mathbf{H}$, the LDPC decoder 822 may now update two or more (even number) associated non-zero variables instead of a single one. If we consider only a single row of the parity-check matrix $\mathbf{H}$, the above update equations remain identical for the general case. If we consider however a block of $S\times S$ entries, i.e., an $S\times S$ sub-matrix of $\mathbf{H}$, we see directly that each associated variable node and the according a-posteriori memory have to be updated twice. One possibility to realize such a row-layered decoder 822 for QCQS LDPC codes is shown in **Fig. 10.**

Fig. 10 will be explained from left to right. First, a chunk of S consecutive a-posteriori LLRs may be fetched from the memory 1010 and, using the two shifts 1015-1, 1015-2 defined by the $m$-th row and the $i$-th column of $\mathbf{A}_1$ and $\mathbf{A}_2$, accordingly rotated. Note that $\text{card}(\mathscr{N}_{\mathbf{A}_1}(m)) = \text{card}(\mathscr{N}_{\mathbf{A}_2}(m)) = \text{card}(\mathscr{N}((m-1)S+s))/2$ (for $s \in [1;S]$) fetches need to be performed (thus dividing the number of memory access by two compared with a row decoder for the same degree profile of a conventional code). Let us consider an example with $S = 9$, $A_{1,m,i}= 1$ and $A_{2,m,i} = 6$. After both shifts 1015-1, 1015-2, we get

$$\widetilde{\mathbf{z}}_i^{(1)} = f_{\text{shift}}(\mathbf{z}_i, A_{1,m,i}) = \begin{pmatrix} z_{i,2} & z_{i,3} & z_{i,4} & z_{i,5} & z_{i,6} & z_{i,7} & z_{i,8} & z_{i,9} & z_{i,1} \end{pmatrix}$$
$$\widetilde{\mathbf{z}}_i^{(2)} = f_{\text{shift}}(\mathbf{z}_i, A_{2,m,i}) = \begin{pmatrix} z_{i,7} & z_{i,8} & z_{i,9} & z_{i,1} & z_{i,2} & z_{i,3} & z_{i,4} & z_{i,5} & z_{i,6} \end{pmatrix}$$

$$(20)$$

For the sake of clarity we only consider in the example the first out of the total S parallel computation engines, so the inputs correspond to the $i$-th entry at the $m$-th row of $\mathbf{A}_1$ and $\mathbf{A}_2$ are $z_{i,2}$ and $z_{i,7}$. Note that $\mathscr{N}_{\mathbf{A}_1} = \mathscr{N}_{\mathbf{A}_2}$ such that we will omit the sub-index "1" or "2" in the following and only use $\mathscr{N}_{\mathbf{A}}$ if the meaning is clear. For clarity reasons only, we do not show the other $2(\text{card}(\mathscr{N}_{\mathbf{A}_i}(m))-1)$ remaining connections for shifter circuits and the connected memory fetching circuits (with each memory fetching circuit being connected to two shifters). As before, we now may compute the temporary values $t_{m,j,s}$ (note the different indexing $j$ to account for the fact that the check node processor 1002 has twice as many entries as $\mathscr{N}_{\mathbf{A}}(m)$) in a first LDPC decoding act of decoder 822 corresponding to

$$\begin{aligned} t_{m,2i-1,s} &= \widetilde{z}_{i,s}^{(1)} - e_{m,2i-1,s} \\ t_{m,2i,s} &= \widetilde{z}_{i,s}^{(2)} - e_{m,2i,s} \end{aligned} \qquad \text{for all } i \in \mathscr{N}_{\mathbf{A}_i}(m) \text{ and } s \in [1;S] \qquad (21)$$

As before, the check node update may be computed using equation (17) or variants / approximations thereof. However, as now two incoming edges of a variable node (in the Tanner graph representation of the code) are updated simultaneously, the computation of the a-posteriori update needs to be modified accordingly and we need to subtract from each of the S a-posteriori entries of the $i$-th chunk the two incoming extrinsic edge values corresponding to the content of the extrinsic memory $e_{m,j,s}$. Let us consider for $j = 2i$ the vector $\mathbf{e}_{m,j} = \mathbf{e}_{m,2i}$. Block 1018 now builds

$$\widetilde{\mathbf{e}}_{m,2i} = f_{\text{shift}}^{-1}(\mathbf{e}_{m,2i}, |A_{2,m,i} - A_{1,m,i}|) = f_{\text{shift}}(\mathbf{e}_{m,2i}, S - |A_{2,m,i} - A_{1,m,i}|)$$

$$\overset{A_{1,m,i}=1, A_{2,m,i}=6}{=} f_{\text{shift}}^{-1}(\mathbf{e}_{m,2i}, 5) = f_{\text{shift}}(\mathbf{e}_{m,2i}, 4) = (e_{m,2i,5} \quad e_{m,2i,6} \quad e_{m,2i,7} \quad e_{m,2i,8} \quad e_{m,2i,9} \quad e_{m,2i,1} \quad e_{m,2i,2} \quad e_{m,2i,3} \quad e_{m,2i,4})$$

$$(22)$$

We can now compute

$$\widetilde{t}_{m,i,s} = t_{m,2i-1,s} - \widetilde{e}_{m,2i,s} = \widetilde{z}_{i,s}^{(1)} - e_{m,2i-1,s} - \widetilde{e}_{m,2i,s}, \quad \text{for all } i \in \mathcal{N}_A(m) \text{ and } s \in [1; S] \quad (23)$$

In our running example we have

$$\widetilde{t}_{m,i,1} = \widetilde{z}_{i,1}^{(1)} - e_{m,2i-1,1} - \widetilde{e}_{m,2i,1} = z_{i,2} - e_{m,2i-1,1} - e_{m,2i,5}$$

$$\widetilde{t}_{m,i,2} = \widetilde{z}_{i,2}^{(1)} - e_{m,2i-1,2} - \widetilde{e}_{m,2i,2} = z_{i,3} - e_{m,2i-1,2} - e_{m,2i,6}$$

$$\vdots$$

$$(24)$$

At the output of the check node processor 1002, we get newly refined extrinsic values $e'_{m,2i-1,s}$ and $e'_{m,2i,s}$, which we may store and add to $\widetilde{t}_{m,i,s}$ to get the a-posteriori values again. That is to say, the LDPC decoder 822 is operable to perform iterative row-layered LDPC decoding, wherein the LDPC decoder 822 may be operable to update, per $S \times S$ sub-matrix, two (or an even number of) variable nodes associated to a non-zero entry with two (or an even number of) refined new extrinsic edge values. Of course we may bring the extrinsic values at output $2i$ again to the same domain as $\widetilde{t}_{m,i,s}$ is. This may again be accomplished by the inverse shift 1020 by $|A_{2,m,i} - A_{1,m,i}|$, yielding $\widetilde{\mathbf{e}}'_{m,2i}$ as outlined above. This means that we now get the updated version

$$\widetilde{z}'^{(1)}_{i,s} = \widetilde{t}_{m,i,s} + e'_{m,2i-1,s} + \widetilde{e}'_{m,2i,s} \qquad \text{for all } i \in \mathcal{N}_A(m) \text{ and } s \in [1; S] \qquad (25)$$

After respective cyclic right shift 1025 by $A_{1,m,i}$, we can write the S entries back to the memory 1010. Note that this is just one possibility to realize the LDPC decoder 822, different other possibilities are also realizable.

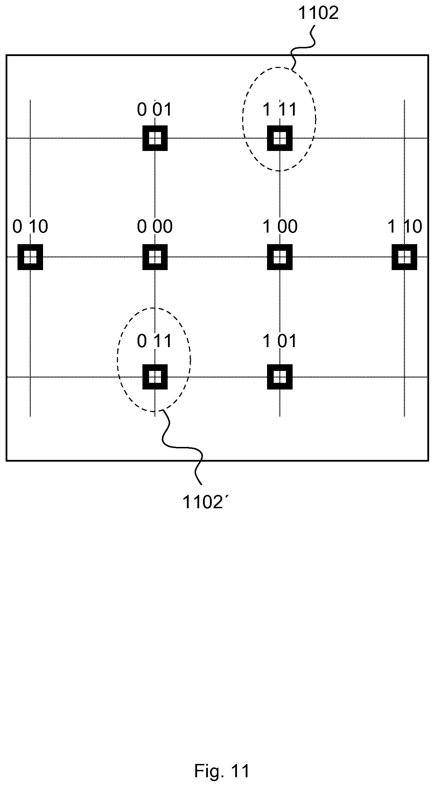

In order to achieve higher spectral efficiencies in coherent optical communications, higher order modulation formats are often employed. These include for instance Quadrature Phase-Shift Keying (QPSK), 8-ary Quadrature Amplitude Modulation (8-QAM), 16-QAM, 32-QAM, etc. One particular format of interest for optical communication systems realizing 200 Gbit/s in a single channel with high reach is the 8-QAM format. With a transmitter operating at 38 GBaud (Giga symbols per second) and employing two polarizations, 228 Gbit/s gross data rate can be transmitted, which accounts for framing overhead and coding. Several different 8-QAM formats exist, however, one particular format of interest is the format shown in **Fig. 11.**

This format or signal constellation has the appealing property that it only has a 180° phase ambiguity, i.e., only phase slips of 180° can occur, as in the BPSK case. In this case, we can employ a bit mapping as in Fig. 11, where the two Least Significant Bits (LSBs) of a 3-bit symbol are mapped in such a way that a 180° rotation of the symbol (a phase slip) does not affect the mapping of the two LSBs. Thus only the Most Significant Bit (MSB) is subject to phase slips and may be protected. In Fig. 11 this is illustrated by the symbol 1102 which maps to symbol 1102' in case of a 180° phase slip.

This means that in the 8-QAM case only one third of the bits (e.g., the MSBs of the symbols) may be protected against phase slips. This can be achieved by interleaving (interleaver $\Pi_M$) the bits such that the MSBs are grouped and designing an LDPC code such that one third of the columns of the LDPC code's parity check matrix **H'** fulfill the quasi-symmetric (QS) code property. Such a partial quasi-symmetric LDPC code is given exemplarily:

$$\mathbf{A}_1 = \begin{pmatrix} -1 & 0 & 1 & -1 & 2 & 4 \\ 2 & -1 & 4 & 2 & -1 & 3 \\ 1 & 0 & -1 & 3 & 1 & 0 \end{pmatrix}$$
$$\mathbf{A}_2 = \begin{pmatrix} -1 & 2 & -1 & -1 & -1 & -1 \\ 3 & -1 & -1 & -1 & -1 & -1 \\ 3 & 3 & -1 & -1 & -1 & -1 \end{pmatrix} \rightarrow \mathbf{H'} =$$

(26)

Here, the entries of a predetermined portion or fraction $b$ (e.g., 2/3) of the columns of the LDPC code's second lifting matrix $\mathbf{A}_2$ correspond to $x$, wherein $x$ (e.g., -1) denotes a predetermined value leading to void or zero entries in the corresponding or associated second parity check matrix $\mathbf{H}_2$. As a result, only a portion or fraction corresponding to 1-$b$ (e.g., 1/3) of the columns of the LDPC code's parity check matrix $\mathbf{H'} = \mathbf{H}_1 + \mathbf{H}_2$ will have the quasi-symmetric code property. Thereby the columns of $\mathbf{H'}$ having the quasi-symmetric property do not have to be placed like in the example. In fact, their location depends on the interleaver and the bit position of the bit (of a multiple-bit symbol) that should be protected against phase slips. That is to say, the columns having the quasi-symmetric property could also be located on the right part of the matrix $\mathbf{H'}$. Likewise the two middle columns could have the quasi-symmetric property. Different arrangements are also possible if the interleaver is properly designed. To summarize, embodiments also comprise code designs defined by an $M'S \times N'S$ parity check matrix $\mathbf{H'}$ which comprises a plurality of $S \times S$ permutation or circulant sub-matrices with an even number of non-zero entries in each row of an $S \times S$ sub-matrix, wherein the plurality of $S \times S$ permutation or circulant sub-matrices forms a portion or fraction of the $N'S$ columns of $\mathbf{H'}$ corresponding to a fraction of bits (of a multiple bit symbol) to be protected against phase slips by the LPDC code.

Note that it is advantageous that the right-most part of the above exemplary matrix $\mathbf{H'}$ (not fulfilling the quasi-symmetric property), i.e., the rightmost 20 columns in the example above, has an odd number of ones per row (if the first third of the code is assumed to be set to zero) of the sub-matrix, such that this sub-code is asymmetric, see A. Scherb and K.-D. Kammeyer, "Non-coherent LDPC decoding on graphs", Proc. IEEE Information Theory Workshop (ITW), Chengdu, China, Oct. 2006, and that the data can be resolved without ambiguity. In the example, the number of ones per row in the rightmost 20 columns of $\mathbf{H'}$ (the columns not fulfilling the quasi-symmetric properties) amounts to 3. In other words, embodiments also comprise code designs defined by an $M'S \times N'S$ parity check matrix $\mathbf{H'}$ comprising a first fraction of $S \times S$ permutation or circulant sub-matrices with an even number of non-zero entries in each row of a sub-matrix and comprising a second fraction of $S \times S$ permutation sub-matrices with an odd number of non-zero entries in each row of a sub-matrix, wherein the first fraction of permutation or circulant $S \times S$ sub-matrices may form a first contiguous fraction of the $N'S$ columns of $\mathbf{H'}$ corresponding to a fraction of bits (of a multiple bit symbol) to be protected against phase slips by the LPDC code, and wherein the second fraction of sub-matrices forms a second fraction (e.g., the rest) of the $N'S$ columns corresponding to a second fraction (e.g., the rest) of bits of the multiple bit symbol. Thereby the second fraction may be obtained by subtracting the first fraction from one. Note that the fraction of the columns need not be contiguous but can be arranged in an arbitrary manner, if the interleaver is properly designed. However, by column rearrangement (and consequently re-design of the interleaver), the matrix can always be brought into a form where the columns are contiguous.

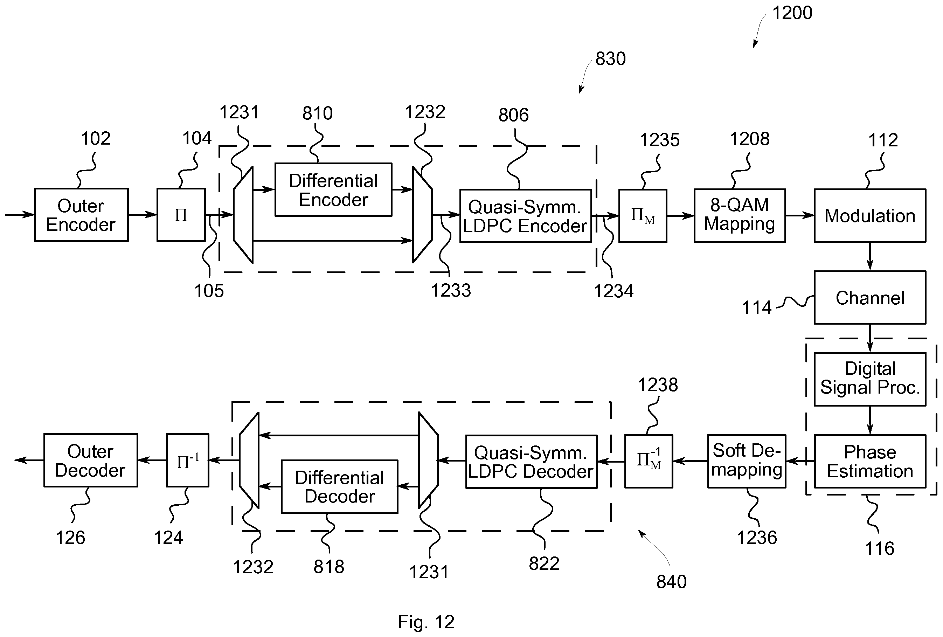

This then allows performing the outer differential encoding 810 and decoding 818 only on, e.g., one third of the data, limiting the error rate at the input of the outer code 102, 126. The according block diagram is shown in **Fig. 12.**

According to the system setup shown in Fig. 12 the outer encoded and interleaved data 105 is de-multiplexed or parallelized by de-multiplexer 1231 to obtain a plurality of parallel bits (e.g., three in the 8-QAM case) per symbol. One or more bits to be especially protected against phase slips may be differentially encoded by differential encoder 810 before the non-differentially-encoded and differentially encoded bits are multiplexed or serialized again by multiplexer 1232 in such a way that the bits to be protected against phase slips are mapped to those columns of the parity check matrix that correspond to the first fraction of permutation or circulant $S \times S$ sub-matrices with an even number of non-zero entries in each row of a sub-matrix. The resulting data stream 1233 is the fed into a QS-LDPC encoder 806 according to an embodiment, which operates according to an LDPC encoding rule that is defined by or based on an $M'S \times N'S$ parity check matrix $\mathbf{H'}$ comprising a plurality of permutation or circulant $S \times S$ sub-matrices with an even number of non-zero entries in each row of an $S \times S$ sub-matrix, wherein the plurality of permutation or circulant $S \times S$ sub-matrices forms a fraction of the $N'S$ columns corresponding to the fraction of differentially encoded bits (of a multiple bit symbol) to be especially protected against phase slips by the LPDC code. The resulting bit stream may then be fed to interleaver $\Pi_M$ 1235, which interleaves the bits located on the fraction of bit positions corresponding to the differentially encoded bits, for example. In the illustrated case of 8-QAM this may be the MSB bit positions, respectively. Subsequently, 8-QAM bit-to-symbol mapping 1208 may take place.

The receiver side of the communication system 1200 carries out the respective inverse operations, i.e., de-mapping 1236, de-interleaving $\Pi_M^{-1}$ 1238, LDPC decoding 822, demultiplexing 1231, differential decoding 818, multiplexing 1232, de-interleaving 124, and outer decoding 126. That is to say, the QS LDPC decoder 822 may operate according to an LDPC decoding rule defined by or based on an $M'S \times N'S$ parity check matrix **H'** comprising a plurality of permutation or circulant $S \times S$ sub-matrices with an even number of non-zero entries in each row of an $S \times S$ sub-matrix, wherein the plurality of permutation or circulant $S \times S$ sub-matrices forms a contiguous fraction (e.g., 1/3) of the $N'S$ columns corresponding to the fraction of differentially encoded bits (of a multiple bit symbol) to be especially protected against phase slips by the LPDC code. Here, contiguous means that the columns comprised by the fraction or portion are contiguously adjacent.

Many higher order modulation formats utilized in the context of coherent optical communications have a phase ambiguity of 90°, i.e., a phase slip of 90° or equivalently a rotation of the constellation diagram by 90°, leads to a constellation indistinguishable from the original constellation. In this case, a QS LDPC code according to embodiments may not be defined over the binary field $F_2$ but over the ring of integer numbers modulo 4, also called $Z_4$. In this case, the entries of the QS parity check matrix **H** are not zeros or ones but numbers 0,1,2,3, and the code is defined to be $C = \{\mathbf{x} \in \{0;1;2;3\}^N \mid \mathbf{Hx}^T \equiv \mathbf{0} \bmod 4\}$. Let us consider again a code sub-divided into chunks of S entries each. Let us consider an parity check equation (where $\{1;5\} \subset \mathcal{N}(m)$ ) and where we assume that $S > 5$ and $\mathcal{N}(m) \cap [1;S] = \{1;5\}$

$$h_1 x_1 + h_5 x_5 + \sum_{i \in \mathcal{N}(m) \setminus \{1;5\}} h_i \, x_i \equiv 0 \bmod 4$$

$$(27)$$

Let us assume that the first $S$ received data symbols are affected by a phase slip of either 90°, 180° or -90°. If the parity check equation has to be fulfilled, this means that

$$h_1(x_1 + 1) + h_5(x_5 + 1) + \sum h_i x_i \equiv 0 \bmod 4$$
$$h_1(x_1 + 2) + h_5(x_5 + 2) + \sum h_i x_i \equiv 0 \bmod 4 \qquad (28)$$
$$h_1(x_1 + 3) + h_5(x_5 + 3) + \sum h_i x_i \equiv 0 \bmod 4$$

have to hold. This can be translated to with knowledge of equation (27)

$$h_1 + h_5 \equiv 0 \bmod 4$$
$$2h_1 + 2h_5 \equiv 0 \bmod 4 . \qquad (29)$$
$$3h_1 + 3h_5 \equiv 0 \bmod 4$$

This means that the entries of the **H**-matrix within a single chunk or $S \times S$ sub-matrix and within each row of the $S \times S$ sub-matrix have to fulfill the condition

$$(ka + kb) \equiv 0 \bmod 4, \; k=1,2,3, \text{ and } a,b \in Z_4. \qquad (30)$$

For the previously introduced example with $S=5$, this means that the only possible combinations in a chunk are the combinations $(a,b)$ with $(a,b) \in \{(1,3);(2,2);(3,1)\}$. This means that the two entries in a row of an $S \times S$ sub-matrix must be either (1,3), (3,1) or (2,2). If a higher, even number of sub-matrices is used, combinations of these entries are possible. An exemplary **H**-matrix can be for instance

$$
\mathbf{H'}=\begin{pmatrix}
& & & 1 & 3 & & 2 & & 2 & 3 & 1 & & 1 & & 3 & \\
& & & & 1 & 3 & 2 & & 2 & & 3 & 1 & & 1 & & 3 \\
& & & & 1 & 3 & 2 & & 2 & & 3 & 1 & & & 1 & 3 \\
& & & 3 & & 1 & & 2 & 2 & & & 3 & 1 & 3 & & 1 \\
& & & 3 & & 1 & 2 & & 2 & 1 & & & 3 & 3 & & 1 \\
& 1 & 3 & & & & 2 & & 2 & 3 & 1 & & & 1 & & 3 \\
& & 2 & 2 & & & 3 & & 1 & & 1 & 3 & 2 & & 2 & \\
1 & & & 3 & & & 1 & & 3 & & 2 & 2 & 3 & & 1 & \\
1 & 3 & & & & & 2 & & 2 & 1 & & & 3 & & 1 & 3 \\
& 2 & 2 & & & & 3 & & 1 & 1 & 3 & & 2 & & 2 & \\
& 1 & & 3 & 1 & & 3 & & & & 1 & 3 & & 1 & 3 & \\
& & 2 & 2 & 2 & & & 2 & & & 2 & 2 & & 2 & & 2 \\
1 & & & 3 & 1 & 3 & & & & 1 & & & 3 & 1 & & 3 \\
& 3 & & 1 & 3 & 1 & & & & 3 & 1 & & & 3 & & 1 \\
2 & & 2 & & & 2 & 2 & & & & 2 & 2 & & 2 & & 2 \\
\end{pmatrix}
\qquad (31)
$$

where in each of the three 5-row chunks we have used different strategies to distribute the allowed non-zero entries. Here, the $M'S \times N'S$ parity check matrix **H'** comprises a plurality of permutation or circulant (non-zero) $S \times S$ sub-matrices with an even number of non-zero entries in each row of each $S \times S$ sub-matrix, wherein the non-zero entries can be from the ring of integer numbers modulo 4.

Here, the decoding 822 may be performed using a non-binary LDPC decoder, as described in H. Wymeersch, H. Steendam, M. Moeneclaey, "Log-Domain Decoding of LDPC codes over GF(q)", IEEE Conf. on Communications (ICC), 2004, where we can also employ a column- or row-layered design and the aforementioned modifications to it. The differential decoder 818 in Fig. 8 may be modified accordingly to a QPSK or higher order decoder. Of course the partially quasi-symmetric code of the previous section to be used with the 8-QAM modulation format can be modified accordingly to be able to work with higher order modulation formats with 90° phase ambiguity, e.g., the square 16-QAM format.

The description and drawings merely illustrate the principles of the invention. It will thus be appreciated that those skilled in the art will be able to devise various arrangements that, although not explicitly described or shown herein, embody the principles of the invention. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

**Claims**

1.  A transmitter, comprising:

    an encoder (830), comprising

    a differential encoder (810) operable to provide a differentially encoded signal (811) based on an input signal (105) and a differential encoding rule;
    an LDPC encoder (806) operable to provide an LDPC encoded signal (807) based on the differentially encoded signal (811) and based on an LDPC encoding rule corresponding to an $M'S \times N'S$ parity check matrix ($\mathbf{H'}$) comprising a plurality of $S \times S$ permutation sub-matrices with an even number of non-zero entries in each row of an $S \times S$ sub-matrix; and
    a digital modulator (112) coupled to an output of the LDPC encoder (806) and operable according to a constellation diagram.

2.  The transmitter of claim 1, wherein the non-zero entries are defined over the binary field $F_2$ or over the ring of integer numbers modulo 4.

3.  The transmitter of claim 1, wherein the differential encoder is operable as a bit differential encoder making a current bit to depend on a previous bit, or a block differential encoder making a current block of bits to depend on a previous block of bits.

4.  The transmitter of claim 1, wherein the LDPC encoding rule is transparent to phase slips caused by a phase noise event affecting the LDPC encoded signal.

5.  The transmitter of claim 1, wherein the parity check matrix ($\mathbf{H'}$) is based on an addition of an even number of parity check matrices ($\mathbf{H_1}$, $\mathbf{H_2}$) corresponding to different quasi-cyclic LDPC codes, respectively.

6.  The transmitter of claim 5, wherein a first parity check matrix ($\mathbf{H_1}$) of the even number of parity check matrices ($\mathbf{H_1}$, $\mathbf{H_2}$) is constructed from a first $M' \times N'$ lifting matrix ($\mathbf{A_1}$) by replacing each entry of the first lifting matrix ($\mathbf{A_1}$) with either an all-zero matrix of size $S \times S$ or a permutation matrix of size $S \times S$, depending on the entry of the first lifting matrix ($\mathbf{A_1}$), wherein a second parity check matrix ($\mathbf{H_2}$) of the even number of parity check matrices ($\mathbf{H_1}$, $\mathbf{H_2}$) is constructed from a second $M' \times N'$ lifting matrix ($\mathbf{A_2}$) by replacing each entry of the second lifting matrix ($\mathbf{A_2}$) with either an all-zero matrix of size $S \times S$ or a permutation matrix of size $S \times S$, depending on the entry of the second lifting matrix ($\mathbf{A_2}$), wherein an entry $A_{1,m,i}$ of the $m$-th row and the $i$-th column of the first lifting matrix ($\mathbf{A_1}$) corresponds to an entry $A_{2,m,i}$ of the $m$-th row and the $i$-th column of the second lifting matrix ($\mathbf{A_2}$) if the entry $A_{1,m,i}$ is $x$, wherein $x$ denotes a predetermined value of the first lifting matrix ($\mathbf{A_1}$) leading to zero entries in the corresponding first parity check matrix ($\mathbf{H_1}$), and wherein an entry $A_{1,m,i} \neq A_{2,m,i} \neq x$ if $A_{1,m,i} \neq x$.

7.  The transmitter of claim 1, wherein the parity check matrix ($\mathbf{H'}$) comprises $M'$ chunks of $S$ rows, wherein $M'$ denotes a number of rows of a lifting matrix ($\mathbf{A_1}$, $\mathbf{A_2}$), wherein each chunk comprises one row with more or less non-zero entries than the other rows of said chunk, such that the parity check matrix ($\mathbf{H'}$) has full rank.

8.  The transmitter of claim 6, wherein entries of a predetermined fraction of columns of the second lifting matrix ($\mathbf{A_2}$)

correspond to $x$, wherein $x$ denotes a predetermined value leading to zero entries in the corresponding second parity check matrix ($H_2$).

9. A method for transmitting a signal, comprising:

differentially encoding an input signal (105) based on a differential encoding rule to obtain a differentially encoded signal (811);
LDPC encoding the differentially encoded signal (811) based on an LDPC encoding rule corresponding to an $M'S \times N'S$ parity check matrix ($H'$) comprising a plurality of $S \times S$ permutation sub-matrices with an even number of non-zero entries in each row of an $S \times S$ sub-matrix; and
modulating the LDPC encoded signal (807) according to a constellation diagram.

10. A receiver, comprising:

digital demodulator (116) operable to demodulate a received signal based on a constellation diagram to obtain an input signal;
a decoder (840), comprising:

an LDPC decoder (822) operable to provide an output signal (823) based on the input signal (821) and based on an LDPC decoding rule corresponding to an $M'S \times N'S$ parity check matrix ($H'$) comprising a plurality of $S \times S$ permutation sub-matrices with an even number of non-zero entries in each row of an $S \times S$ sub-matrix; and
a differential decoder (818) operable to provide a decoded signal (819) based on the output signal (823) from the LDPC decoder (822) and a differential decoding rule.

11. The receiver of claim 10, wherein the parity check matrix ($H'$) corresponds to an addition of an even number of parity check matrices ($H_1$, $H_2$) corresponding to different quasi-cyclic LDPC codes, respectively.

12. The receiver of claim 11, wherein a first parity check matrix ($H_1$) of the even number of parity check matrices ($H_1$, $H_2$) is constructed from a first lifting matrix ($A_1$) by replacing each entry of the first lifting matrix ($A_1$) with either an all-zero matrix of size $S \times S$ or a permutation matrix of size $S \times S$, depending on the entry of the first lifting matrix ($A_1$), wherein a second parity check matrix ($H_2$) of the even number of parity check matrices ($H_1$, $H_2$) is constructed from a second lifting matrix ($A_2$) by replacing each entry of the second lifting matrix ($A_2$) with either an all-zero matrix of size $S \times S$ or a permutation matrix of size $S \times S$, depending on the entry of the second lifting matrix ($A_2$), wherein an entry $A_{1,m,i}$ of the $m$-th row and the $i$-th column of the first lifting matrix ($A_1$) corresponds to an entry $A_{2,m,i}$ of the $m$-th row and the $i$-th column of the second lifting matrix ($A_2$) if the entry $A_{1,m,i}$ is $x$, wherein $x$ denotes a predetermined value of the first lifting matrix ($A_1$) leading to zero entries in the corresponding first parity check matrix ($H_1$), and wherein an entry $A_{1,m,i} \neq A_{2,m,i} \neq x$ if $A_{1,m,i} \neq x$.

13. The receiver of claim 10, wherein LDPC decoder is operable to perform iterative row-layered LDPC decoding, wherein the LDPC decoder is operable to update, per $S \times S$ sub-matrix, a variable node associated to a non-zero entry twice per iteration.

14. A method for receiving a signal, comprising:

digitally demodulating the received signal based on a constellation diagram to obtain an input signal;
LDPC decoding the input signal to provide an output signal based on the input signal and an LDPC decoding rule corresponding to a parity check matrix ($H'$) comprising a plurality of $S \times S$ permutation sub-matrices with an even number of non-zero entries in each row of an $S \times S$ sub-matrix; and
differentially decoding the output signal to provide a decoded signal based on the output signal from the LDPC decoder and a differential decoding rule.

15. Computer program having a program code for performing the method of claim 9 or claim 14, when the computer program is executed on a programmable hardware device.

**Patentansprüche**

1. Sender, umfassend:

   einen Codierer (830), umfassend

   einen Differenzcodierer (810), der betriebsfähig ist, ein differenziell codiertes Signal (811) basierend auf einem Eingangssignal (105) und einer Differenzcodierregel bereitzustellen;
   einen LDPC-Codierer (806), der betriebsfähig ist, ein LDPC-codiertes Signal (807) basierend auf dem differenziell codierten Signal (811) und basierend auf einer LDPC-Codierregel entsprechend einer $M'SxN'S$-Paritätsprüfungsmatrix (**H'**) bereitzustellen, umfassend eine Vielzahl von $SxS$-Permutationsuntermatrizen mit einer geraden Zahl von Nicht-Null-Einträgen in jeder Zeile einer $SxS$-Untermatrix; und
   einen digitalen Modulator (112), der an einen Ausgang des LDPC-Codierers (806) gekoppelt und gemäß einem Konstellationsdiagramm betriebsfähig ist.

2. Sender nach Anspruch 1, wobei die Nicht-Null-Einträge über das binäre Feld F2 oder über den Ring aus ganzen Zahlen Modulo 4 definiert werden.

3. Sender nach Anspruch 1, wobei der Differenzcodierer als Bitdifferenzcodierer betriebsfähig ist, der ein aktuelles Bit von einem vorherigen Bit abhängig macht, oder als Blockdifferenzcodierer, der einen aktuellen Block von Bits von einem vorherigen Block von Bits abhängig macht.

4. Sender nach Anspruch 1, wobei die LDPC-Codierregel für Phasengleiten transparent ist, das von einem Phasenrauschereignis verursacht wird, das das LDPC-codierte Signal beeinträchtigt.

5. Sender nach Anspruch 1, wobei die Paritätsprüfungsmatrix (**H'**) auf einer Addition einer geraden Zahl von Paritätsprüfungsmatrizen (**H₁**, **H₂**) basiert, die jeweils unterschiedlichen quasizyklischen LDPC-Codes entsprechen.

6. Sender nach Anspruch 5, wobei eine erste Paritätsprüfungsmatrix (**H₁**) von der geraden Zahl von Paritätsprüfungsmatrizen (**H₁**, **H₂**) aus einer ersten $M'xN'$-Lifting-Matrix (**A₁**) konstruiert wird durch Ersetzen jedes Eintrags der ersten Lifting-Matrix (**A₁**) entweder durch eine Nullmatrix der Größe $SxS$ oder eine Permutationsmatrix der Größe $SxS$, je nach Eintrag der ersten Lifting-Matrix (**A₁**), wobei eine zweite Paritätsprüfungsmatrix (**H₂**) von der geraden Zahl von Paritätsprüfungsmatrizen (**H₁**, **H₂**) aus einer zweiten $M'xN'$-Lifting-Matrix (**A₂**) konstruiert wird durch Ersetzen jedes Eintrags der zweiten Lifting-Matrix (**A₂**) entweder durch eine Nullmatrix der Größe $SxS$ oder eine Permutationsmatrix der Größe $SxS$, je nach Eintrag der zweiten Lifting-Matrix (**A₂**), wobei ein Eintrag $A_{1,m,i}$ der $m$-ten Zeile und der $i$-ten Spalte der ersten Lifting-Matrix (**A₁**) einem Eintrag $A_{2,m,i}$ der $m$-ten Zeile und der $i$-ten Spalte der zweiten Lifting-Matrix (**A₂**) entspricht, wenn der Eintrag $A_{1,m,i}$ x ist, wobei x einen vorbestimmten Wert der ersten Lifting-Matrix (**A₁**) bezeichnet, der zu null Einträgen in der entsprechenden ersten Paritätsprüfungsmatrix (**H₁**) führt, und wobei ein Eintrag $A_{1,m,i} \neq A_{2,m,i} \neq$ x wenn $A_{1,m,i} \neq$ x.

7. Sender nach Anspruch 1, wobei die Paritätsprüfungsmatrix (**H'**) $M'$ Blöcke von S Zeilen umfasst, wobei $M'$ eine Zahl von Zeilen einer Lifting-Matrix (**A₁**, **A₂**) bezeichnet, wobei jeder Block eine Zeile mit mehr oder weniger Nicht-Null-Einträgen als die anderen Zeilen des besagten Blocks umfasst, so dass die Paritätsprüfungsmatrix (**H'**) vollen Rang hat.

8. Sender nach Anspruch 6, wobei Einträge eines vorbestimmten Teils von Spalten der zweiten Lifting-Matrix (**A₂**) x entsprechen, wobei x einen vorbestimmten Wert bezeichnet, der zu null Einträgen in der entsprechenden zweiten Paritätsprüfungsmatrix (**H₂**) führt.

9. Verfahren zur Übertragung eines Signals, umfassend:

   differenzielles Codieren eines Eingangssignals (105) basierend auf einer Differenzcodierregel, um ein differenziell codiertes Signal (811) zu erhalten;
   LDPC-Codieren des differenziell codierten Signals (811), basierend auf einer LDPC-Codierregel entsprechend einer $M'SxN'S$-Paritätsprüfungsmatrix (**H'**), umfassend eine Vielzahl von $SxS$-Permutationsuntermatrizen mit einer geraden Zahl von Nicht-Null-Einträgen in jeder Zeile einer $SxS$-Untermatrix; und
   Modulieren des LDPC-codierten Signals (807) gemäß einem Konstellationsdiagramm.

**10.** Empfänger, umfassend:

einen digitalen Demodulator (116), der betriebsfähig ist, ein empfangenes Signal basierend auf einem Konstellationsdiagramm zu demodulieren, um ein Eingangssignal zu erhalten;
einen Decodierer (840), umfassend:

einen LDPC-Decodierer (822), der betriebsfähig ist, ein Ausgangssignal (823) basierend auf dem Eingangssignal (821) und basierend auf einer LDPC-Decodierregel entsprechend einer $M'SxN'S$-Paritätsprüfungsmatrix (**H'**) bereitzustellen, umfassend eine Vielzahl von $SxS$-Permutationsuntermatrizen mit einer geraden Zahl von Nicht-Null-Einträgen in jeder Zeile einer $SxS$-Untermatrix; und
einen Differenzdecodierer (818), der betriebsfähig ist, ein decodiertes Signal (819) basierend auf dem Ausgangssignal (823) von dem LDPC-Decodierer (822) und einer Differenzdecodierregel bereitzustellen.

**11.** Empfänger nach Anspruch 10, wobei die Paritätsprüfungsmatrix (**H'**) einer Addition einer geraden Zahl von Paritätsprüfungsmatrizen (**H₁**, **H₂**) entspricht, die jeweils unterschiedlichen quasizyklischen LDPC-Codes entsprechen.

**12.** Empfänger nach Anspruch 11, wobei eine erste Paritätsprüfungsmatrix (**H₁**) von der geraden Zahl von Paritätsprüfungsmatrizen (**H₁**, **H₂**) aus einer ersten Lifting-Matrix (**A₁**) konstruiert wird durch Ersetzen jedes Eintrags der ersten Lifting-Matrix (**A₁**) entweder durch eine Nullmatrix der Größe $SxS$ oder eine Permutationsmatrix der Größe $SxS$, je nach Eintrag der ersten Lifting-Matrix (**A₁**), wobei eine zweite Paritätsprüfungsmatrix (**H₂**) von der geraden Zahl von Paritätsprüfungsmatrizen (**H₁**, **H₂**) aus einer zweiten Lifting-Matrix (**A₂**) konstruiert wird durch Ersetzen jedes Eintrags der zweiten Lifting-Matrix (**A₂**) entweder durch eine Nullmatrix der Größe $SxS$ oder eine Permutationsmatrix der Größe $SxS$, je nach Eintrag der zweiten Lifting-Matrix (**A₂**), wobei ein Eintrag $A_{1,m,i}$ der $m$-ten Zeile und der $i$-ten Spalte der ersten Lifting-Matrix (**A₁**) einem Eintrag $A_{2,m,i}$ der $m$-ten Zeile und der $i$-ten Spalte der zweiten Lifting-Matrix (**A₂**) entspricht, wenn der Eintrag $A_{1,m,i}$ $x$ ist, wobei $x$ einen vorbestimmten Wert der ersten Lifting-Matrix (**A₁**) bezeichnet, der zu null Einträgen in der entsprechenden ersten Paritätsprüfungsmatrix (**H₁**) führt, und wobei ein Eintrag $A_{1,m,i} \neq A_{2,m,i} \neq x$ wenn $A_{1,m,i} \neq x$.

**13.** Empfänger nach Anspruch 10, wobei der LDPC-Decodierer betriebsfähig ist, eine iterative zeilenweise LDPC-Decodierung durchzuführen, wobei der LDPC-Decodierer betriebsfähig ist, pro $SxS$-Untermatrix, einen variablen Knoten, der zu einem Nicht-Null-Eintrag zugehörig ist, zwei Mal pro Iteration zu aktualisieren.

**14.** Verfahren zum Empfangen eines Signals, umfassend:

digitales Demodulieren des empfangenen Signals basierend auf einem Konstellationsdiagramm, um ein Eingangssignal zu erhalten;
LDPC-Decodieren des Eingangssignals zum Bereitstellen eines Ausgangssignals basierend auf dem Eingangssignal und auf einer LDPC-Decodierregel entsprechend einer Paritätsprüfungsmatrix (**H'**), umfassend eine Vielzahl von $SxS$-Permutationsuntermatrizen mit einer geraden Zahl von Nicht-Null-Einträgen in jeder Zeile einer $SxS$-Untermatrix; und
differenzielles Decodieren des Ausgangssignals zum Bereitstellen eines decodierten Signals basierend auf dem Ausgangssignal von dem LDPC-Decodierer und einer Differenzdecodierregel.

**15.** Computerprogramm mit einem Programmcode zum Durchführen des Verfahrens nach Anspruch 9 oder Anspruch 14, wenn das Computerprogramm auf einer programmierbaren Hardwarevorrichtung ausgeführt wird.

**Revendications**

**1.** Émetteur, comprenant :

un codeur (830), comprenant

un codeur différentiel (810) permettant de délivrer un signal codé de façon différentielle (811) à partir d'un signal d'entrée (105) et d'une règle de codage différentiel ;
un codeur LDPC (806) permettant de délivrer un signal à codage LDPC (807) à partir du signal codé de façon différentielle (811) et d'une règle de codage LDPC correspondant à une matrice de contrôle de parité $M'SxN'S$ (**H'**) comprenant une pluralité de sous-matrices de permutation $SxS$ avec un nombre pair d'entrées non nulles dans chaque ligne d'une sous-matrice *SxS* ; et

un modulateur numérique (112) connecté à une sortie du codeur LDPC (806) et pouvant fonctionner selon un diagramme de constellation.

2. Émetteur selon la revendication 1, dans lequel les entrées non nulles sont définies sur le champ binaire $F_2$ ou sur l'anneau de nombres entiers modulo 4.

3. Émetteur selon la revendication 1, dans lequel le codeur différentiel peut fonctionner comme un codeur différentiel de bits faisant dépendre un bit courant d'un bit précédent, ou un codeur différentiel de blocs faisant dépendre un bloc de bits courant d'un bloc de bits précédent.

4. Émetteur selon la revendication 1, dans lequel la règle de codage LDPC est transparente aux glissements de phase provoqués par un événement de bruit de phase affectant le signal à codage LDPC.

5. Émetteur selon la revendication 1, dans lequel la matrice de contrôle de parité (**H'**) est basée sur l'addition d'un nombre pair de matrices de contrôle de parité (**H₁**, **H₂**) correspondant à différents codes LDPC quasi-cycliques, respectivement.

6. Émetteur selon la revendication 5, dans lequel une première matrice de contrôle de parité (**H₁**) du nombre pair de matrices de contrôle de parité (**H₁**, **H₂**) est élaborée à partir d'une première matrice de transfert *M'xN'* (**A₁**) en remplaçant chaque entrée de la première matrice de transfert (**A₁**) soit par une matrice nulle de taille *SxS,* soit par une matrice de permutation de taille *SxS,* en fonction de l'entrée de la première matrice de transfert (**A₁**), dans lequel une deuxième matrice de contrôle de parité (**H₂**) du nombre pair de matrices de contrôle de parité (**H₁**, **H₂**) est élaborée à partir d'une deuxième matrice de transfert *M'xN'* (**A₂**) en remplaçant chaque entrée de la deuxième matrice de transfert (**A₂**) soit par une matrice nulle de taille *SxS,* soit par une matrice de permutation de taille *SxS,* en fonction de l'entrée de la deuxième matrice de transfert (**A₂**), dans lequel une entrée $A_{1,m,i}$ de la ligne de rang m et la colonne de rang i de la première matrice de transfert (**A₁**) correspond à une entrée $A_{2,m,i}$ de la ligne de rang m et la colonne de rang i de la deuxième matrice de transfert (**A₂**) si l'entrée $A_{1,m,i}$ vaut *x*, où *x* représente une valeur prédéterminée de la première matrice de transfert (**A₁**) conduisant à des entrées nulles dans la première matrice de contrôle de parité (**H₁**) correspondante, et où une entrée $A_{1,m,i} \neq A_{2,m,i} \neq x$ si $A_{1,m,i} \neq x$.

7. Émetteur selon la revendication 1, dans lequel la matrice de contrôle de parité (**H'**) comprend *M'* blocs de *S* lignes, où *M'* représente un nombre de lignes d'une matrice de transfert (**A₁, A₂**), chaque bloc comprenant une ligne avec plus ou moins d'entrées non nulles que les autres lignes dudit bloc, de sorte que la matrice de contrôle de parité (**H'**) soit à rang complet.

8. Émetteur selon la revendication 6, dans lequel les entrées d'une fraction prédéterminée de colonnes de la deuxième matrice de transfert (**A₂**) correspondent à *x*, où *x* représente une valeur prédéterminée conduisant à des entrées nulles dans la deuxième matrice de contrôle de parité (**H₂**) correspondante.

9. Procédé de transmission de signal, comprenant les étapes suivantes :

coder de façon différentielle un signal d'entrée (105) à partir d'une règle de codage différentiel pour obtenir un signal codé de façon différentielle (811) ;
effectuer un codage LDPC du signal codé de façon différentielle (811) à partir d'une règle de codage LDPC correspondant à une matrice de contrôle de parité *M'S×N'S* (**H'**) comprenant une pluralité de sous-matrices de permutation *SxS* avec un nombre pair d'entrées non nulles dans chaque ligne d'une sous-matrice *SxS* ; et
moduler le signal à codage LDPC (807) selon un diagramme de constellation.

10. Récepteur, comprenant :

un démodulateur numérique (116) permettant de démoduler un signal reçu selon un diagramme de constellation pour obtenir un signal d'entrée ;
un décodeur, comprenant :

un décodeur LDPC (822) permettant de délivrer un signal de sortie (823) à partir du signal d'entrée (821) et d'une règle de décodage LDPC correspondant à une matrice de contrôle de parité *M'SxN'S* (**H'**) comprenant une pluralité de sous-matrices de permutation *SxS* avec un nombre pair d'entrées non nulles dans chaque ligne d'une sous-matrice *SxS ;* et

un décodeur différentiel (818) permettant de délivrer un signal décodé (819) à partir du signal de sortie (823) du décodeur LDPC (822) et d'une règle de décodage différentiel.

**11.** Récepteur selon la revendication 10, dans lequel la matrice de contrôle de parité (**H'**) correspond à l'addition d'un nombre pair de matrices de contrôle de parité (**H₁**, **H₂**) correspondant à différents codes LDPC quasi-cycliques, respectivement.

**12.** Récepteur selon la revendication 11, dans lequel une première matrice de contrôle de parité (**H₁**) du nombre pair de matrices de contrôle de parité (**H₁**, **H₂**) est élaborée à partir d'une première matrice de transfert *M'xN'* (**A₁**) en remplaçant chaque entrée de la première matrice de transfert (**A₁**) soit par une matrice nulle de taille *SxS,* soit par une matrice de permutation de taille *SxS,* en fonction de l'entrée de la première matrice de transfert (**A₁**), dans lequel une deuxième matrice de contrôle de parité (**H₂**) du nombre pair de matrices de contrôle de parité (**H₁**, **H₂**) est élaborée à partir d'une deuxième matrice de transfert (**A₂**) en remplaçant chaque entrée de la deuxième matrice de transfert (**A₂**) soit par une matrice nulle de taille *SxS,* soit par une matrice de permutation de taille *SxS,* en fonction de l'entrée de la deuxième matrice de transfert (**A₂**), dans lequel une entrée $A_{1,m,i}$ de la ligne de rang m et la colonne de rang i de la première matrice de transfert (**A₁**) correspond à une entrée $A_{2,m,i}$ de la ligne de rang m et la colonne de rang i de la deuxième matrice de transfert (**A₂**) si l'entrée $A_{1,m,i}$ vaut *x*, où *x* représente une valeur prédéterminée de la première matrice de transfert (**A₁**) conduisant à des entrées nulles dans la première matrice de contrôle de parité (**H₁**) correspondante, et où une entrée $A_{1,m,i} \neq A_{2,m,i} \neq$ x si $A_{1,m,i} \neq$ x.

**13.** Récepteur selon la revendication 10, dans lequel le décodeur LDPC permet de réaliser un décodage LDPC itératif à plusieurs niveaux de ligne, dans lequel le décodeur LDPC permet de mettre à jour, par sous-matrice SxS, un noeud variable associé à une entrée non nulle deux fois par itération.

**14.** Procédé de réception de signal, comprenant les étapes suivantes :

démoduler numériquement le signal reçu selon un diagramme de constellation pour obtenir un signal d'entrée ; effectuer un décodage LDPC du signal d'entrée pour délivrer un signal de sortie à partir du signal d'entrée et d'une règle de décodage LDPC correspondant à une matrice de contrôle de parité (H') comprenant une pluralité de sous-matrices de permutation SxS avec un nombre pair d'entrées non nulles dans chaque ligne d'une sous-matrice SxS ; et

décoder de façon différentielle le signal de sortie pour délivrer un signal décodé à partir du signal de sortie du décodeur LDPC et d'une règle de décodage différentiel.

**15.** Programme informatique comportant un code de programme destiné à mettre en oeuvre le procédé selon la revendication 9 ou la revendication 14, lorsque le programme informatique est exécuté sur un dispositif matériel programmable.

EP 2 833 554 B1

Fig. 1

Fig. 2

Fig. 3

EP 2 833 554 B1

Fig. 4

Fig. 5

600

nz = 60000

Fig. 6

Fig. 7

Fig. 8

EP 2 833 554 B1

Fig. 9a

Fig. 9b

Fig. 10

Fig. 11

Fig. 12

EP 2 833 554 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2538596 A1
- EP 2506516 A1

### Non-patent literature cited in the description

- TM SYNCHRONIZATION AND CHANNEL CODING- SUMMARY OF CONCEPT AND RATIONALE. GREEN BOOK, 01 November 2012, 1-127
- **D. E. HOCEVAR.** A Reduced Complexity Decoder Architecture via Layered Decoding of LDPC Codes. *Proc. IEEE Workshop on Signal Processing Systems (SIPS),* 2004
- **J. CHEN ; A. DHOLAKIA ; E. ELEFTHERIOU ; M. P. C. FOSSORIER ; X.-Y. HU.** Reduced-Complexity Decoding of LDPC Codes. *IEEE Transactions on Communications,* August 2005, vol. 53 (8), 1288-1299
- **L. R. BAHL ; J. COCKE ; F. JELINEK ; J. RAVIV.** Optimal Decoding of Linear Codes for minimizing symbol error rate. *IEEE Transactions on Information Theory,* March 1974, vol. IT-20 (2), 284-287
- **J. HAGENAUER ; E. OFFER ; L. PAPKE.** Iterative Decoding of Binary Block and Convolutional Codes. *IEEE Trans. Inform. Theory,* March 1996, vol. 42 (2
- **A. SCHERB ; K.-D. KAMMEYER.** Non-coherent LD-PC decoding on graphs. *Proc. IEEE Information Theory Workshop (ITW),* October 2006
- **W.E. RYAN ; S. LIN.** Channel Codes - Classical and Modern. Cambridge University Press, 2009
- **H. WYMEERSCH ; H. STEENDAM ; M. MOENE-CLAEY.** Log-Domain Decoding of LDPC codes over GF(q). *IEEE Conf. on Communications (ICC),* 2004